**Europäisches Patentamt**

**European Patent Office**

**Office européen des brevets**

(19)

(11) Numéro de publication : **0 398 442 B1**

(12)

# FASCICULE DE BREVET EUROPEEN

(45) Date de publication du fascicule du brevet :
**16.08.95 Bulletin 95/33**

(51) Int. Cl.$^6$ : **H03H 11/12, H03H 11/04**

(21) Numéro de dépôt : **90201243.4**

(22) Date de dépôt : **16.05.90**

(54) **Dispositif semiconducteur incluant un filtre actif dans le domaine des hautes et hyperfréquences.**

(30) Priorité : **19.05.89 FR 8906553**

(43) Date de publication de la demande :
**22.11.90 Bulletin 90/47**

(45) Mention de la délivrance du brevet :
**16.08.95 Bulletin 95/33**

(84) Etats contractants désignés :
**DE FR GB**

(56) Documents cités :
**EP-A- 0 312 145**
**US-A- 3 517 223**
**US-A- 4 292 468**

(73) Titulaire : **LABORATOIRES D'ELECTRONIQUE PHILIPS**
**3, Avenue Descartes**
**F-94450 Limeil-Brévannes (FR)**
(84) **FR**
Titulaire : **Philips Electronics N.V.**
**Groenewoudseweg 1**
**NL-5621 BA Eindhoven (NL)**
(84) **DE GB**

(72) Inventeur : **Deville, Yannick**
**Société Civile SPID,**
**156, Boulevard Haussmann**
**F-75008 Paris (FR)**

(74) Mandataire : **Landousy, Christian et al**
**Société Civile S.P.I.D.**
**156, Boulevard Haussmann**
**F-75008 Paris (FR)**

**EP 0 398 442 B1**

## Description

L'invention concerne un dispositif semiconducteur incluant un filtre actif dans le domaine des hautes et hyperfréquences, ce filtre présentant une entrée et une sortie asymétriques, référencées par rapport à la masse, et comportant entre cette entrée et cette sortie :

- une première branche comprenant un amplificateur de fonction de transfert H(s) et une première impédance $Z_1$ en série,
- une seconde branche comprenant une seconde impédance $Z_2$.

L'invention trouve son application dans la réalisation de circuits intégrés formant filtres dans le domaine des hautes et hyperfréquences pouvant par exemple sous une forme de réalisation être utilisés comme coupe-bande dans les doubleurs de fréquence pour rejeter le signal indésirable à la fréquence fondamentale, ou bien pouvant sous une autre forme de réalisation être utilisés comme passe-tout en tant que déphaseur ajustable à une fréquence donnée, ou encore comme passe-tout utilisé dans les déphaseurs 0-90° large bande.

Un tel circuit est déjà connu de l'état de la technique par le brevet US 4 292 468. La figure 3 de ce document montre un filtre passe-bande comprenant une première branche avec un amplificateur et une première impédance et une seconde branche avec une seconde impédance, ce filtre ayant une entrée et une sortie asymétriques et référencées par rapport à la masse. Dans le circuit décrit dans le document cité, le circuit amplificateur a un gain constant négatif présentant une valeur réelle (par opposition à complexe). Les impédances sont constituées de filtres RC dont l'un est du type parallèle dans la seconde branche et du type série dans la première branche comprenant l'amplificateur. Mais les valeurs des résistances et des capacités sont obligatoirement égales entre elles, pour atteindre le but visé par le circuit qui est de fournir un filtre actif ayant des paramètres indépendants les uns des autres.

Ce circuit n'est pas contrôlable électriquement et par conséquent sa fonction est fixée à celle d'un circuit passe-bande sans autre possibilité. Enfin ce circuit utilise comme circuit amplificateur un amplificateur opérationnel qui, comme il est connu de l'homme du métier ne permet pas d'atteindre des fréquences élevées.

Or dans la conception des circuits, la demande est pour des circuits fonctionnant à des fréquences toujours plus élevées (hyperfréquences notamment) et de plus en plus performants, par exemple contrôlable électriquement, avec une faible consommation, peu d'éléments, et impérativement intégrable.

Le but de la présente invention est de proposer de nouveaux circuits plus simples et donc plus compacts et plus facilement intégrables ainsi que des circuits qui permettent d'atteindre des fréquences centrales plus élevées que celles décrites dans le document cité.

Selon l'invention ces buts sont atteints au moyen d'un dispositif tel que décrit dans le préambule en outre caractérisé en ce que :

- le circuit amplificateur de la première branche est choisi entre un circuit amplificateur ayant une fonction de transfert H(s) d'ordre 0, et un circuit amplificateur ayant une fonction de transfert H(s) PASS-BAS d'ordre 1, pour fixer la gamme de fréquences de fonctionnement du filtre actif ;
- le gain basse fréquence de la fonction de transfert H(S) du circuit amplificateur de la première branche est contrôlé par des moyens de réglage appliqués à ce circuit qui agissent en coopération avec la valeur et la configuration des impédances $Z_1$ et $Z_2$ pour ajuster les caractéristiques du filtre actif, dans ladite gamme de fréquences de fonctionnement, entre les caractéristiques de filtre coupe-bande et celles de filtre passe-tout ;
- la fonction de transfert du filtre actif est d'ordre 2.

Le circuit selon l'invention n'utilise en aucun cas d'amplificateur différentiel. Ce circuit est contrôlable électriquement, donc la bande des fréquences de fonctionnement peut être choisie. Elle peut notamment être choisie dans la gamme autour de 1 GHz ou bien dans la gamme de 1 à 10 GHz ou bien dans une gamme encore plus élevée, par exemple 15 GHz.

Et dans chacune de ces gammes, le cicuit est continuement réglable de passe-bande à passe-tout. Il en résulte qu'en associant deux circuits réglés en passe-tout on peut réaliser des déphaseurs 0-90° d'une façon particulièrement performante.

Le circuit peut aussi couvrir des bandes plus larges, le rapport entre les fréquences extrêmes est grand lorsque le filtre est utilisé en passe-tout pour faire des déphaseurs 0-90°, et la bande où l'on obtient le déphasage de 90° est située haut en fréquence car, du fait de l'ordre 2, on peut obtenir l'ajustage du filtre en faisant varier de nombreux paramètres.

On notera que le filtre selon l'invention reste cependant asymétrique, c'est-à-dire que les sorties et entrées sont disponibles entre un point du filtre et la masse, ce qui permet d'insérer un tel circuit entre n'importe quels autres circuits ; d'autre part, les éléments du filtre n'ont pas besoin d'être impérativement appariés, ce qui rend la conception du circuit intégré plus facile, du fait que souvent des problèmes de dispersion apparaissent lors de leur réalisation. Dans ce cas, la fonction de transfert n'est pas dégradée du fait de la dispersion des caractéristiques des éléments du circuit comme il apparaît lorsque le circuit utilise des amplificateurs différentiels par exemple.

Le circuit peut être réalisé en différents matériaux semiconducteurs.

L'invention sera mieux comprise au moyen de la description suivante illustrée par les figures annexées dont :

- la figure 1a qui représente un filtre selon l'invention dans une application haute fréquence ;
- la figure 1b qui représente une mise en oeuvre du filtre de la figure 1a au moyen de transistors à effet de champ ;
- la figure 1c qui représente une mise en oeuvre du filtre de la figure 1a pour réaliser un déphaseur 0-90° ;
- la figure 2a qui représente un filtre selon l'invention dans une application très haute fréquence ;
- la figure 2b qui représente une mise en oeuvre du filtre selon la figure 2a au moyen de transistors à effet de champ ;
- la figure 2c qui représente une mise en oeuvre du filtre de la figure 2a dans une application à un déphaseur 0-90° ;
- la figure 2d qui représente le module du gain en dB du circuit selon la figure 2b ;
- la figure 2e qui représente l'écart de phase entre les deux signaux de sorties du circuit de la figure 2c ;
- la figure 2f qui représente le rapport des modules des deux signaux de sortie du circuit de la figure 2c.
- la figure 3a qui représente un filtre selon l'invention pour une application hyperfréquences ;
- la figure 3b qui représente une mise en oeuvre du filtre de la figure 3a au moyen de transistors à effet de champ ;
- la figure 3c qui représente une mise en oeuvre du filtre de la figure 3a pour l'application à un déphaseur 0-90° ;
- la figure 3d qui représente le module du gain en dB du circuit selon la figure 3b ;
- la figure 3e qui représente l'écart de phase entre les deux signaux de sortie du circuit de la figure 3c ;
- la figure 3f qui représente le rapport des modules des deux signaux de sortie du circuit de la figure 3c ;
- la figure 3g qui représente le module du gain du premier des deux filtres que comporte le circuit de la figure 3c ;
- la figure 3h qui montre les rapports des modules des deux signaux de sortie du circuit de la figure 3c dans des conditions de polarisation différentes de celles de la figure 3f ;
- la figure 3i qui montre l'écart de phase entre les deux signaux de sortie du circuit de la figure 3c dans les mêmes conditions de polarisation que celles de la figure 3h.
- la figure 3j qui montre l'écart de phase entre les deux signaux de sortie du circuit de la figure 3c dans des conditions de polarisation différentes de celles des figures 3h et 3i ;
- la figure 3k qui montre le rapport des modules des deux signaux de sortie du circuit de la figure 3c dans les conditions de polarisation de la figure 3j.
- la figure 4 qui représente schématiquement un déphaseur 0-90° ;
- la figure 5 qui représente un étage tampon qui qui peut être avantageusement appliqué à la sortie du filtre selon l'invention ;
- la figure 6 qui représente un schéma de principe du filtre selon l'invention.

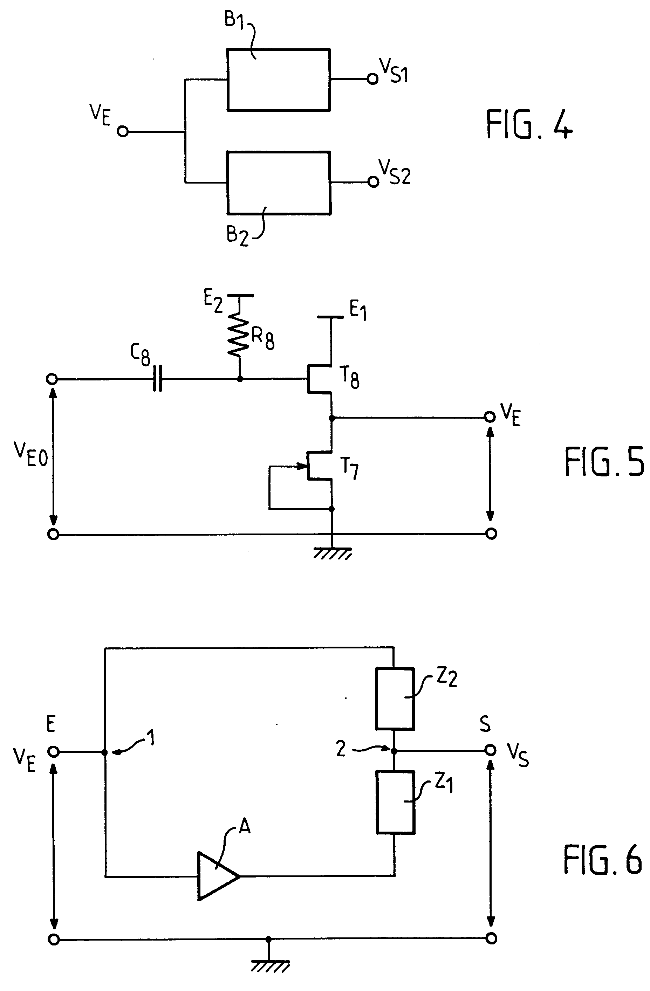

Tel que représenté sur la figure 6, le filtre selon l'invention comprend deux branches entre une entrée E et une sortie S : une branche principale qui comprend un amplificateur A et une impédance $Z_1$ en série, et une seconde branche qui comprend une impédance $Z_2$. Le signal d'entrée $V_E$ est appliqué entre le noeud 1 et la masse et le signal de sortie $V_S$ est prélevé entre le noeud 2 et la masse. Le filtre selon l'invention est donc asymétrique, il ne comprend pas d'amplificateur différentiel ; les éléments qui le constituent n'ont pas besoin d'être appariés, ce qui est toujours difficile à réaliser dans un circuit intégré du fait de la dispersion des caractéristiques des différents éléments et notamment des transistors.

Un des buts de l'invention est la réalisation de filtres d'ordre 2 continûment ajustables de coupe-bande à passe-tout. L'intérêt du montage selon l'invention est d'atteindre des fréquences centrales très élevées. La fonction de transfert du circuit de la figure 6 est donnée par la relation (1) du tableau I. Dans cette expression :

G est le gain total du filtre,
s est la variable de Laplace,
$\omega_1$ est la pulsation associée aux zéros de G(s),
$\omega_0$ est la pulsation associée aux pôles de G(s),
$Q_0$ est la sélectivité ou facteur de qualité du filtre,
$Q_1$ est le facteur de réjection du filtre.

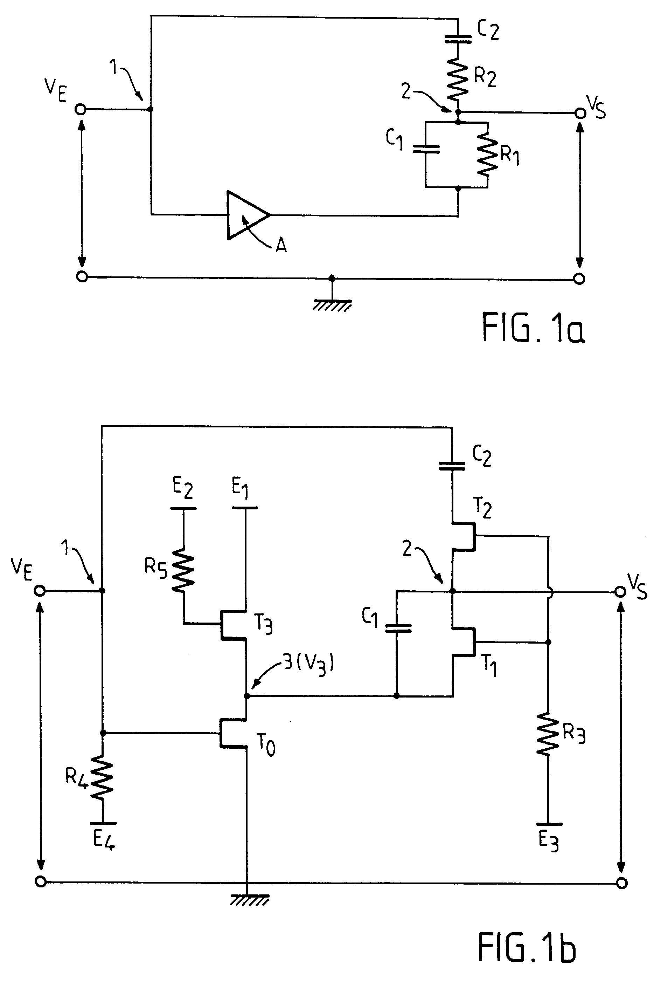

La figure 1a représente le filtre de la figure 6 dans une mise en oeuvre haute fréquence. Dans cette mise en oeuvre, l'impédance $Z_1$ est constituée par un filtre $C_1 R_1$ parallèle et l'impédance $Z_2$ par un filtre $C_2 R_2$ série.

3

Dans ces conditions la fonction de transfert H(s) de l'amplificateur est d'ordre 0, le gain de l'amplificateur A étant donné par H(S) = -k, le gain total du filtre sera G = -k.

Les pulsations $\omega_1$ et $\omega_0$ sont égales entre elles et égale à la valeur donnée par la relation (6) du tableau I ; les valeurs de $Q_1$ et $Q_0$ sont données respectivement par les relations (7) et (8) du tableau I. Le circuit de la figure 1a est utilisé loin de la fréquence de coupure de l'amplificateur. Le circuit selon l'invention a pour but de permettre de passer continûment du filtre coupe-bande au filtre passe-tout ; à cet effet, il suffit de régler le gain de l'amplificateur A.

La figure 1b est un exemple de réalisation du circuit de la figure 1a au moyen de transistors à effet de champ. Un tel circuit peut être mis en oeuvre par exemple au moyen de transistors à effet de champ en arséniure de gallium.

Dans le circuit de la figure 1b l'amplificateur A est formé du transistor amplificateur $T_0$, dont la source est reliée à la masse et dont le drain est relié au transistor de charge $T_3$. Le drain du transistor de charge $T_3$ est relié directement à une alimentation continue $E_1$ et la grille du transistor de charge $T_3$ est polarisée par une alimentation $E_2$ à travers une résistance $R_5$. Le signal d'entrée $V_E$ est appliqué entre la grille ou point 1 du transistor amplificateur $T_0$ et la masse. La grille du transistor amplificateur $T_0$ est polarisée par une tension du polarisation négative $E_4$ à travers une résistance $R_4$.

Les résistances $R_1$ et $R_2$ des impédances $Z_1$ et $Z_2$ respectivement sont formées par des transistors $T_1$ et $T_2$ disposés de manière à présenter une électrode commune au point 2. Les grilles de ces transistors sont reliées entre elles et polarisées par une tension de polarisation continue $E_3$ négative par rapport à la polarisation de $V_S$ à travers une résistance $R_3$. Le signal de sortie est prélevé entre le point 2 commun aux impédances $Z_1$ et $Z_2$ et la masse.

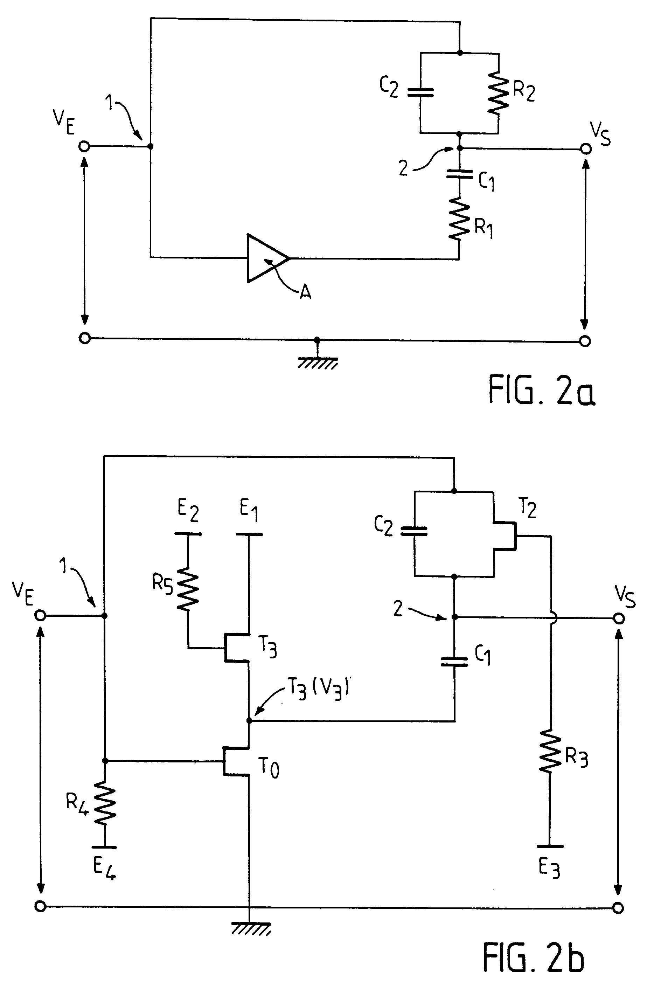

La figure 2a représente une mise en oeuvre du filtre selon l'invention applicable à des plus hautes fréqences, par exemple entre 1 et 9 GHz. Dans cette mise en oeuvre, l'impédance $Z_1$ est formée par un filtre $R_1$ $C_1$ série et l'impédance $Z_2$ par un filtre $R_2$ $C_2$ parallèle.

Le gain de l'amplificateur est donné par la fonction de transfert d'ordre 0 H(s) = -k, k étant une constante. Dans ces conditions le gain total du filtre selon l'invention G = 1, les pulsations $\omega_1$ et $\omega_0$ sont égales entre elles et égales à la relation (6bis) du tableau I. Les facteurs $Q_1$ et $Q_0$ sont donnés respectivement par les relations (7bis) et (8bis) du tableau I.

La figure 2b représente un exemple de réalisation du circuit de la figure 2a au moyen de transistors à effet de champ, par exemple en arséniure de gallium. L'amplificateur est formé comme dans le circuit de la figure 1b par le transistor amplificateur $T_0$ dont la source est portée à la masse, dont le drain est relié à la charge $T_3$ et dont la grille est polarisée par la tension de polarisation négative $E_4$ à travers la résistance $R_4$. L'impédance $Z_1$ formée d'une résistance et d'une capacité en série est réalisée au moyen de la résistance de sortie du transistor $T_0$ et de la capacité $C_1$. L'impédance $Z_2$ est formée de la capacité $C_2$ et du transistor $T_2$ fonctionnant en résistance dont la grille est polarisée par la tension de polarisation $E_3$ négative par rapport à la tension de polarisation $E_4$ à travers la résistance $R_3$.

Le tableau II donne les valeurs des éléments pour mettre en oeuvre le circuit de la figure 1b et le tableau IV donne la valeurs des éléments pour mettre en oeuvre le circuit de la figure 2b dans les exemples décrits précédemment.

Les circuits selon l'invention représentés sur les figures 1a, et 2a, sont utilisables soit en coupe-bande soit en passe-tout, et continûment ajustables de coupe-bande à passe-tout en agissant sur le facteur $Q_1$.

Si par exemple on fixe :
les résistances $R_1 = R_2$,
et les capacités $C_1 = C_2$,
on obtiendra :
- pour le circuit de la figure 1a
  l'application coupe-bande pour k = 0,5
  et l'application passe-tout pour k = 0,2, c'est-à-dire respectivement dans les conditions où $Q_1 = \infty$ et $Q_1 = -Q_0$ ;
- et pour le circuit de la figure 2a :
  l'application coupe-bande pour k = 2
  et l'application passe-tout pour k = 5.

Ces fonctions sont réalisées dans chacun de ces deux circuits avec des valeurs relativement faibles de k, ce qui permet d'utiliser ces circuits à de très hautes fréquences où seuls des amplificateurs de faible gain sont disponibles.

Le circuit de la figure 2a présente l'avantage de posséder un gain basse fréquence G indépendant de k et unitaire, ce qui est en particulier très utile dans le cas de l'application passe-tout : le montage remplit alors sont rôle de modification de la phase du signal d'entrée, mais ne modifie pas son amplitude ; le circuit de la

4

figure 1a présente l'avantage d'utiliser un gain encore plus faible que celui du circuit de la figure 2a.

Si les circuits des figures 1a et 2a doivent être chargés par un système dont l'impédance d'entrée est très faible, il peut être utile de les faire suivre par un étage tampon à forte impédance d'entrée et faible impédance de sortie, tel que celui représenté sur la figure 5.

Tel que représenté, tout à fait à titre d'exemple, sur la figure 5, un tel étage tampon peut être constitué d'un transistor $T_8$ dont le drain est polarisé directement par l'alimentation $E_1$ du filtre dans sa mise en oeuvre représentée par exemple sur la figure 1b, ou 2b. La source du transistor $T_8$ est reliée à la masse par l'intermédiaire du transistor source de courant $T_7$ dont la source et la grille court-circuitées sont communes à la masse. La grille du transistor $T_8$ est polarisée à travers une résistance $R_8$. La sortie des circuits des figures 1b ou 2b est alors portée en $V_{EO}$ de l'étage tampon de la figure 5 et la sortie disponible est $V_E$ entre la source du transistor $T_8$ et la masse. Le condensateur $C_8$ est un condensateur de découplage.

Concernant les exemples de réalisation représentés sur les figures 1b et 2b, le circuit de la figure 2b présente des avantages sur celui de la figure 1b :

- l'amplificateur utilisé pratiquement a une résistance de sortie $R_S$ non négligeable par rapport à l'impédance de $R_1$, $R_2$, $C_1$ et $C_2$. Pour le circuit de la figure 2b, $R_S$ s'ajoute simplement à $R_1$. Dans les équations de ce circuit $R_1$ est changée en $R'_1 = R_1 + R_S$, mais la fonction de transfert conserve la forme donnée par la relation (1) du tableau I.

Au contraire pour le montage de la figure 1b un nouveau pôle important apparaît et la fonction de transfert n'a plus tout à fait la forme de la relation (1) du tableau I.

Concernant également les circuits 1b et 2b, l'amplificateur réel apporte un retard de phase. Ce retard affecte moins les performances du circuit de la figure 2b que celles du circuit de la figure 1b.

Pour les circuits idéaux des figures 2a et 1a, quand $\omega$ tend vers l'infini, G tend vers 1 pour le circuit de la figure 2a, et G tend vers k pour le circuit 1a.

Pour les réalisations pratiques correspondantes c'est-à-dire les circuits des figures 2b et 1b, quant $\omega$ tend vers l'infini l'effet de la coupure de l'amplificateur se traduit maintenant par k tend vers 0 dans G(S) du montage initial donc :

pour le circuit pratique de la figure 2b :

$\omega$ tend vers l'infini, k tend vers 0, $G(J\omega)$ tend vers 1.

pour le circuit pratique de la figure 1b :

$\omega$ tend vers l'infini, k tend vers 0, entraîne que $G(j\omega)$ tend vers 0.

Il en résulte que pour le circuit pratique déduit de la figure 2a, le comportement pour $\omega$ tendant vers l'infini n'est pas altéré par la coupure de l'amplificateur utilisé, alors qu'il l'est pour le circuit pratique déduit du circuit théorique de la figure 1a.

Pour toutes ces raisons le circuit pratique de la figure 1b déduit du circuit théorique de la figure 1a sera utilisé à des fréquences plus basses, par exemple inférieures à 1 Ghz, que le montage pratique représenté sur la figure 2b et déduit du circuit théorique de la figure 2a.

Dans l'un et l'autre des circuits représentés sur la figure 1b et sur la figure 2b, l'amplificateur est réalisé par le transistor $T_0$. Son gain k est réglé de préférence par une tension, ici par la tension de polarisation $E_4$ à travers la résistance $R_4$. Si l'on souhaite régler la valeur de k et par conséquent la valeur du coefficient $Q_1$, plus finement, on peut séparer le transistor amplificateur $T_0$ en deux transistors placés en parallèle, pour l'alternatif, et polarisés par deux tensions de polarisation continue différentes. On utilisera alors un transistor de grande dimension pour le réglage grossier de la constante k, et un transistor de petite dimension pour le réglage fin de k. Les tensions de réglage peuvent être générées à l'extérieur du circuit intégré, ou sur le même substrat par un autre bloc. D'autres moyens pour régler le gain de l'amplificateur sont possibles, tels que l'utilisation d'éléments ajustables comme charge. La charge ajustable peut être un transistor.

Dans les dispositifs représentés sur les figures 1b et 2b, la tension de polarisation $E_2$ sert à polariser la grille du transistor de charge $T_3$, et débite donc un très faible courant. On peut de ce fait la remplacer par un plot de résistance, à condition que celui-ci soit bien découplé en alternatif par un condensateur. En effet la résistance de polarisation $R_5$ est choisie de manière à limiter le retard de phase de l'amplificateur, et son point commun à la tension de polarisation $E_2$ doit être une masse en alternatif.

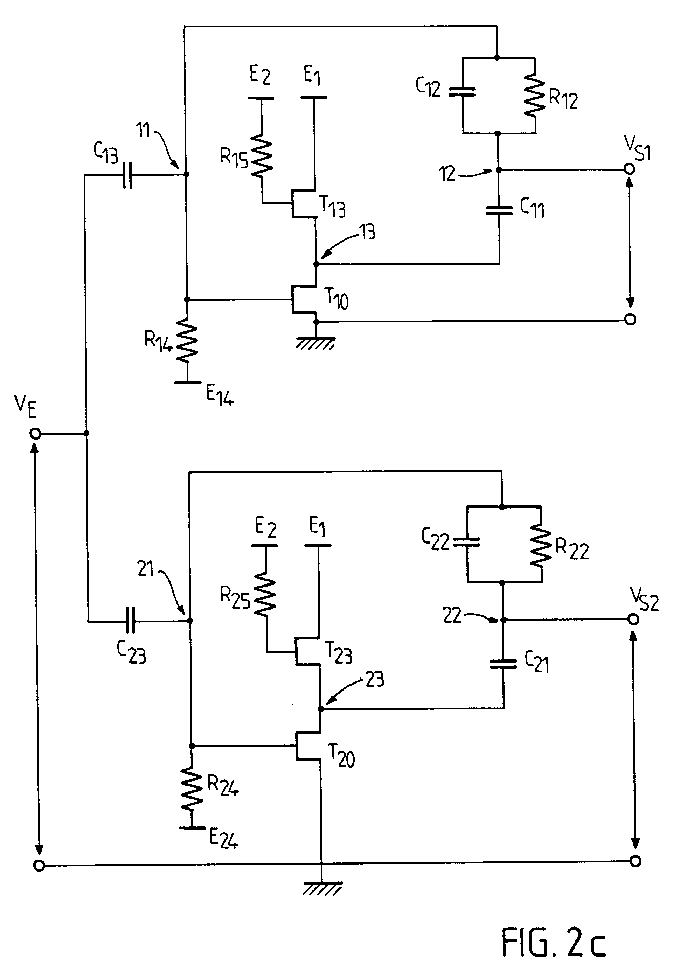

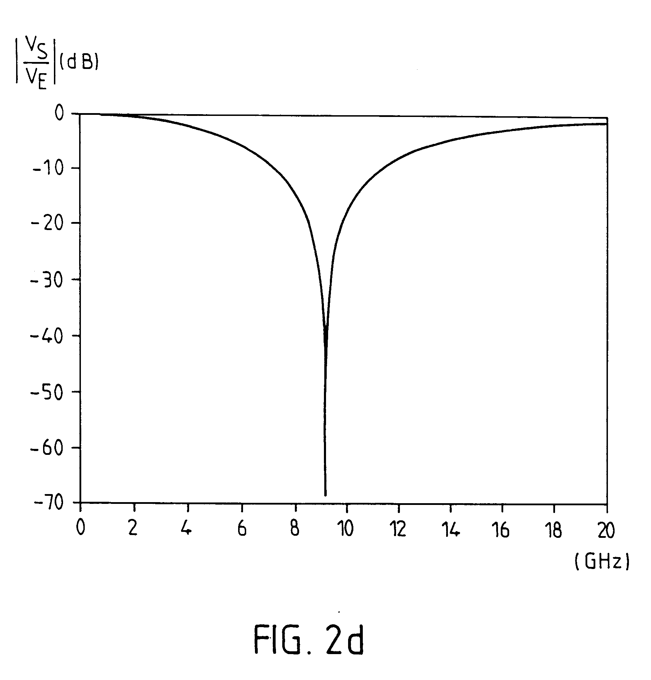

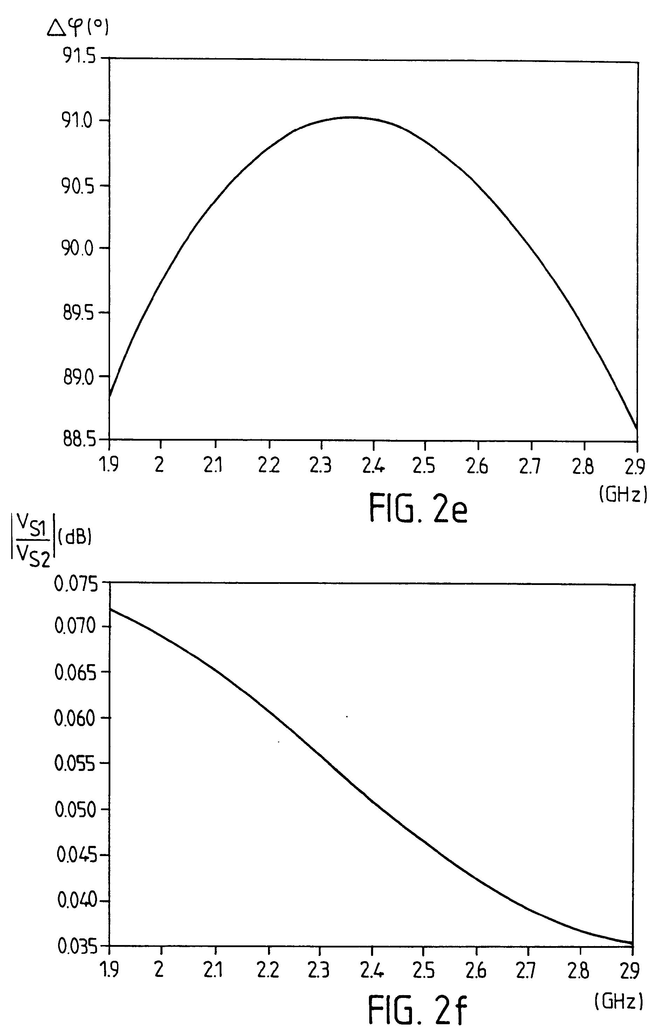

Comme on l'a vu précédemment, la résistance de l'impédance $Z_1$, c'est-à-dire $R'_1 = R_1 + R_S$ est uniquement constituée sur le montage de la figure 2, de la résistance de sortie du transistor $T_0$, il n'apparaît pas de résistance $R_1$. La résistance $R_2$ est remplacée par le transistor $T_2$ utilisé en résistance ($V_{DS} = 0$), dont la valeur est ajustée par la tension de polarisation négative $E_3$, ce qui permet de faire varier la pulsation centrale du filtre $\omega_1$. Pour le circuit de la figure 2b les caractéristiques du montage utilisé en coupe-bande sont alors :

Fréquence centrale : $F_1 = \omega_1/2\pi$

pour $E_3 = 0$ V, $F_1 \simeq 9,2$ GHz,

pour $E_3 = -1,8$ V, $F_1 \simeq 4,2$ GHz,

pour $E_3$ < -1,8 V, $F_1$ diminue si $E_3$ diminue mais devient plus difficile à ajuster.

Toutes les valeurs de $E_3$ mentionnées sont référencées par rapport à $E_4$, non pas par rapport à la masse.

Réjection (c'est-à-dire rapport entre les gaines du filtre aux très basses fréquences et à la fréquence centrale) :

si $E_4$ est contrôlé à $\pm$ 25 mV, le circuit de la figure 2b garantit une réjection > à 42 dB à la fréquence $F_1$ $\simeq$ à 9,2 GHz,

une réjection > à 48 dB à $F_1$ $\simeq$ 4,2 GHz,

Gain :

on a $|V_S/V_E| \to 1$ quand $\omega \to 0$ et $\omega \to \infty$, comme on peut le vérifier sur la courbe donnée par la figure 2d à titre d'exemple.

Polarisation :

Dans le cas où la fréquence centrale $F_1 \simeq$ 9,2 GHz, on utilise $E_4 \simeq$ -0,775 V,

Dans le cas où la fréquence centrale $F_1 \simeq$ 4,2 GHz, on utilise $E_4 \simeq$ -1,9 V.

A titre d'exemple, les caractéristiques pour $E_3$ = 0 V et $E_4$ = -0,775 V sont données sur la figure 2d.

Les caractéristiques du circuit de la figure 2b ne sont pas altérées quand on l'insère dans un montage, si l'on place derrière lui le suiveur donné en figure 5. Le circuit de la figure 5 présente une impédance de sortie proche de 50 Ohms pour l'ensemble filtre de la figure 2b plus suiveur de la figure 5, en prenant les mêmes polarisations que celles de la figure 2b. On obtient alors les mêmes caractéristiques en fréquence centrale et réjection sauf en ce qui concerne le gain qui devient égal à celui de l'étage suiveur, soit environ -1,8 dB pour une fréquence inférieure à 20 GHz, et un gain qui tend vers 0 quand $\omega$ vers l'infini.

Si le montage qui vient en entrée du filtre selon l'invention ne comporte pas de condensateur de découplage, alors il faut placer un tel condensateur de découplage en entrée du filtre selon l'invention, car c'est la polarisation $E_4$ qui doit fixer la polarisation de grille du transistor amplificateur $T_0$. Dans ce cas, seul le gain du filtre est modifié. Ainsi pour une valeur de condensateur $C_D$ = 5 pF, la chute de gain est de l'ordre de 1 dB à 0,1 GHz et 0,3 dB à 20 GHz.

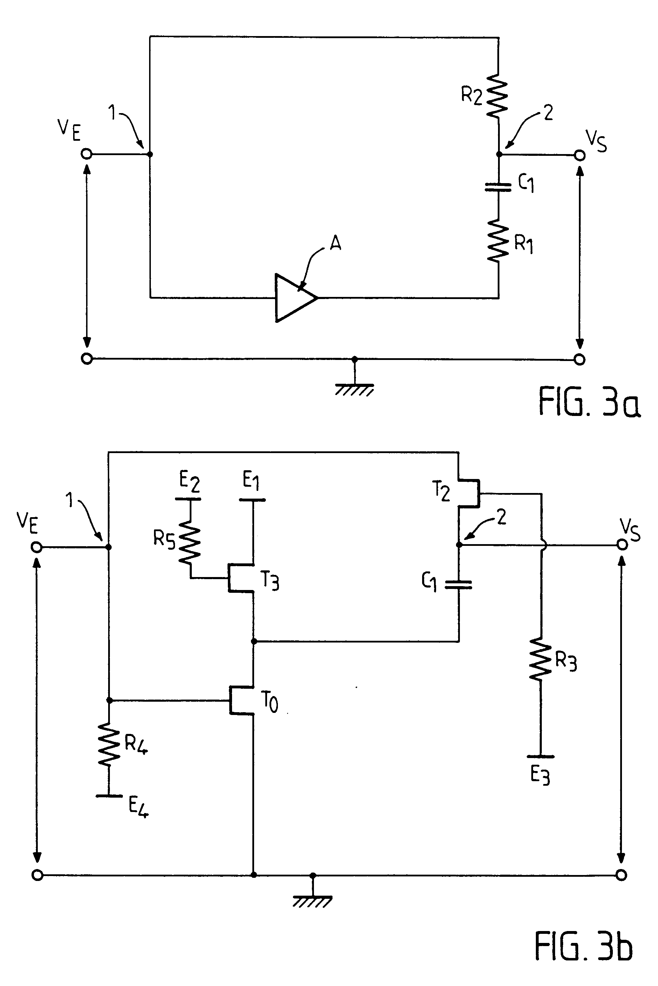

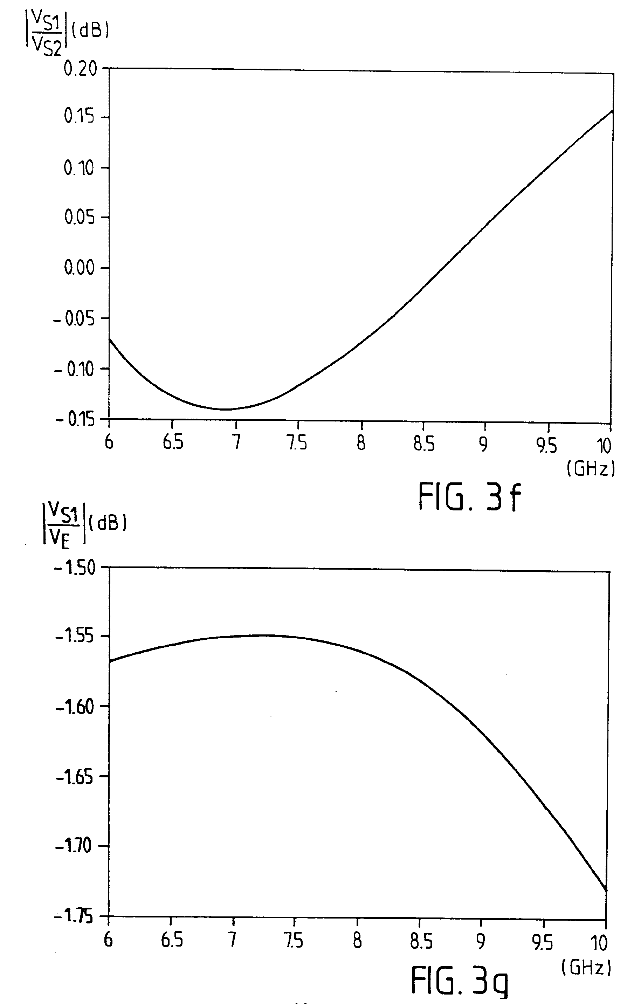

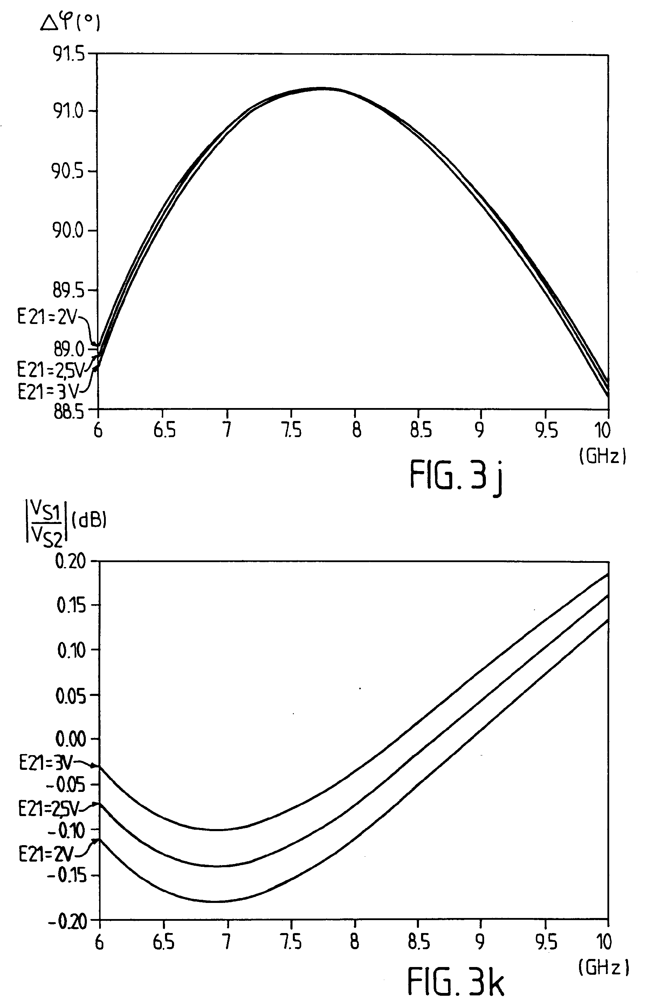

Tel que représenté sur la figure 3a, le filtre selon l'invention peut atteindre de très hautes fréquences. L'impédance $Z_1$ est alors constituée d'une résistance $R_1$ et d'une capacité $C_1$ en série et l'impédance $Z_2$ est constituée d'une résistance $R_2$.

Dans la fonction de transfert G(s) donnée par la relation 1 du tableau I, le gain total du circuit G = 1, les pulsations $\omega_0$ et $\omega_1$ sont données par les relations (6ter) et (6quater) du tableau I et les coefficients $Q_0$ et $Q_1$ respectivement par les relations (8ter) et (7ter).

Le circuit de la figure 3a peut réaliser $Q_1 \infty$, et donc être utilisé en coupe-bande. Par contre, $\omega_1$ est différente de $\omega_0$, donc il ne peut réaliser la fonction passe-tout strictement parlant mais seulement une fonction pseudo-passe-tout. L'avantage par rapport au montage des figures 1a et 2a est que le bloc amplificateur A est un passe-bas d'ordre 1 dont le gain H(s) = -k/($\tau$s + 1). Ceci peut être réalisé par un étage amplificateur inverseur utilisé près de sa fréquence de coupure. Alors la fréquence de coupure de l'étage amplificateur n'est plus un phénomène parasite du montage pratique, qui limite la valeur maximale de la fréquence centrale, comme cela était le cas pour le dispositif de la figure 1a, mais devient un des paramètres qui déterminent la fréquence centrale du filtre actif. Ainsi la fréquence centrale du filtre actif peut être plus grande que celle de l'un des montages des figures 1a ou 2a.

La figure 3b représente un exemple de réalisation du montage de la figure 3a. En pratique l'amplificateur a une impédance de sortie $R_S$. De ce fait, la fonction de transfert reste de la forme G(S), comme la relation 1 du tableau mais la résistance $R_1$ est changée en $R'_1 = R_1 + R_S$. Puisque l'on cherche à monter très haut en fréquence, on aura intérêt à prendre $R_1$ = 0 et donc $R'_1 = R_S$ la résistance de sortie de l'amplificateur.

Le montage pratique hyperfréquences montré sur la figure 3b est réalisé au moyen de transistors à effet de champ par exemple en arséniure de gallium. Bien que par sa forme il ressemble au montage pratique de la figure 2b, avec la particularité de présenter une capacité $C_1$ = 0, il faut se souvenir que l'approche du circuit de la figure 2b est différente.

En effet si dans le montage de la figure 2b on fait $C_1$ = 0, on obtient :

$$V_S/V_E = [(R_1 - kR_2) C_1 s + 1]/[(R_1 + R_2) C_1 s + 1]$$

et l'on ne peut prévoir l'effet coupe-bande que l'on obtient ici en utilisant la coupure de l'amplificateur.

Comme dans les montages précédents : l'étage amplificateur est réalisé par le transistor $T_0$ chargé par $T_3$. le transistor $T_0$ amplificateur peut être scindé en deux.

La tension de polarisation négative $E_4$ règle le gain de l'amplificateur $T_0$. Ce gain peut aussi être réglé par d'autres moyens comme dit précédemment.

La tension de polarisation $E_2$ peut être remplacée par un pont de résistances bien découplées ;

la résistance $R'_1$ est constituée par la résistance de sortie du transistor amplificateur $T_0$ ;

la résistance $R_2$ de l'impédance $Z_2$ est remplacée par le transistor $T_2$ ajustable par la tension de polarisation $E_3$ négative par rapport à la tension de polarisation $E_4$ ajustant la pulsation $\omega_0$ donc la pulsation de coupure.

Les caractéristiques de ce filtre utilisé en coupe-bande sont :

-fréquence centrale (on appelle la fréquence centrale du filtre la fréquence $F_{CB}$ où son gain est minimal. Elle est très proche de $F_1$) :

pour $E_3 = 0$ V, $F_{CB} \simeq 14,9$ GHz,

pour $E_3 = -0,95$ V, $F_{CB} \simeq 11,3$ GHz,

pour $E_3 < -0,95$ V, on est alors obligé d'utiliser $E_4$ assez bas, et k devient plus difficile à régler.

Ici aussi, toutes les valeurs de $E_3$ mentionnées sont référencées par rapport à $E_4$, non pas par rapport à la masse.

Réjection :

Si $E_4$ est contrôlé à $\pm 25$ mV, on garantit : une réjection supérieure ou égale à 45 dB à la fréquence $F_{CB}$ $\simeq 14,9$ GHz,

une réjection supérieure ou égale à 39 dB à la fréquence $F_{CB} \simeq 11,3$ GHz.

Gain :

On a bien $|V_S/V_E| \to 1$ quand $\omega \to 0$,

et $|V_S/V_E| \to$ vers une valeur inférieure à 1 (car $\omega_0 < \omega_1$) quand $\omega \to \infty$, comme on peut le vérifier sur la courbe 3d donnée ci-après à titre d'exemple.

Polarisation :

Dans le cas où $F_{CB} \simeq 14,9$ GHz, on utilise $E_4 \simeq -0,875$ V

Dans le cas ou $F_{CB} \simeq 11,3$ GHz, on utilise $E_4 \simeq -2$ V.

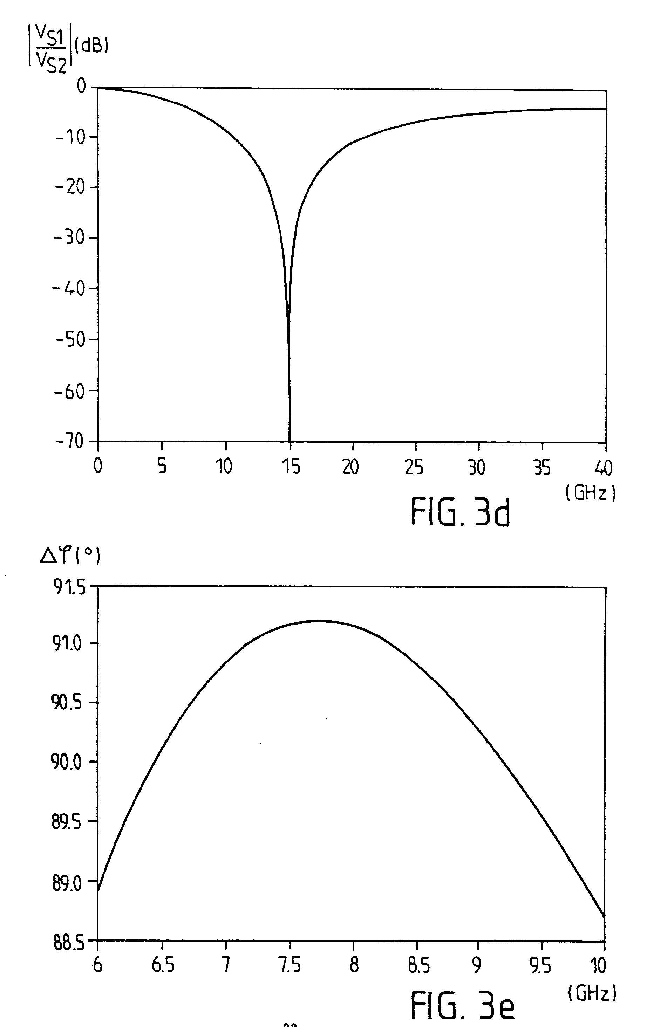

A titre d'exemple, les caractéristiques pour $E_3 = 0$ V et $E_4 = -0,875$ V sont données sur la figure 3d.

Le fait de charger le montage de la figure 3b par le suiveur de la figure 5, ou de placer un condensateur de découplage à son entrée, présente le même effet que sur le montage de la figure 2b.

Dans toutes les caractéristiques données précédemment, on n'a pas tenu compte des capacités parasites du montage, car elles ne sont pas liées au montage proposé, mais dépendent de la mise en oeuvre de la technologie.

Au moyen des filtres selon l'invention, lorsqu'ils sont réglés en passe-tout, on peut réaliser des déphaseurs actifs 0-90° utilisant deux de ces filtres passe-tout ou pseudo-passe-tout d'ordre 2, dont les sorties fournissent des signaux de même amplitude et en quadrature de phase. Le déphaseur réalisé fonctionne alors dans le domaine des hyperfréquences. Ces circuits déphaseurs trouvent leur application dans la réalisation de mélangeurs à réjection de fréquence image destinés, par exemple à des têtes de réception de signaux retransmis par satellite artificiel ou de signaux hertziens en général. L'invention trouve aussi son application dans la réalisation de modulateurs 4 phases.

Un circuit de ce type est connu de l'état de la technique par l'article intitulé "Monolithic RC All-Pass Networks with Constant Phase Difference Outputs". Ce circuit présente plusieurs inconvénients :

- les cellules passe-tout utilisées travaillent en différentiel donc contiennent beaucoup d'éléments, ce qui rend le circuit complexe et augmente les risques de dégradation des performances dues au dispersions sur les valeurs des éléments ;
- du fait que les passe-tout utilisent une entrée différentielle, il faut placer devant ces cellules un circuit qui permet de passer d'un signal référencé par rapport à la masse (signal le plus souvent utilisé), à un signal différentiel nécessaire pour reconstituer l'entrée de ces cellules. D'une part, ce circuit-additionnel complique considérablement le montage. D'autre part il fournit des signaux qui ne sont pas rigoureusement en opposition de phase et de même amplitude (voir la publication citée p. 1537), ce qui dégrade les caractéristiques globales du déphaseur ;
- l'impédance de sortie des suiveurs placée en amont des cellules passe-tout n'est pas prise en compte dans la mise en équations du circuit. A cause de cette impédance, la fonction de transfert des cellules n'est pas en fait du type passe-tout. Pour que cette impédance ne dégrade pas les performances, il faut que les impédances utilisées dans les cellules passe-tout soient notablement plus fortes qu'elles, ce qui limite l'utilisation du circuit connu à des fréquences assez faibles.

Il existe aussi des déphaseurs qui utilisent des cellules passe-tout d'ordre 1 telle que la publication intitulée "Development of Key monolithic circuits to Ka-band full MMIC receivers" par Takashi Ohira and alii dans IEEE 1987 Microwave and Millimeter wave Monolithic Circuits Symposium p.69 à 74.

Mais les déphaseurs connus de ce deuxième document cité ne sont utilisables que dans des applications à bande étroite. Si la différence de phase entre deux sorties ne doit pas s'écarter de plus de 1° degré de sa valeur nominale 90°, alors le rapport entre les deux fréquences limites de la bande utile est de 1,7 quand on utilise des passe-tout d'ordre 1, tandis qu'il peut atteindre 10 avec des passe-tout d'ordre 2.

Enfin si la fréquence centrale la plus élevée des deux passe-tout est fixée, la bande d'utilisation du déphaseur, c'est-à-dire la bande où les deux sorties sont en quadrature de phase, se situe à des fréquences plus élevées quand on utilise des passe-tout d'ordre 2 que lorsqu'on utilise des passe-tout d'ordre 1. L'utilisation de passe-tout d'ordre 2 est donc susceptible de permettre la réalisation de déphaseurs travaillant à des plus hautes fréquences.

Le schéma fonctionnel général d'un déphaseur réalisé au moyen de deux cellules passe-tout est donné sur la figure 4. Ce déphaseur comprend une première cellule $B_1$ et une seconde cellule $B_2$ qui reçoivent toutes deux un signal d'entrée $V_E$ référencé par rapport à la masse et fournissent chacun une sortie respectivement $V_{S1}$ et $V_{S2}$.

Les cellules ont pour fonction de transfert, pour $B_1$ la relation 1bis du tableau I et pour $B_2$ la relation 1ter du tableau I.

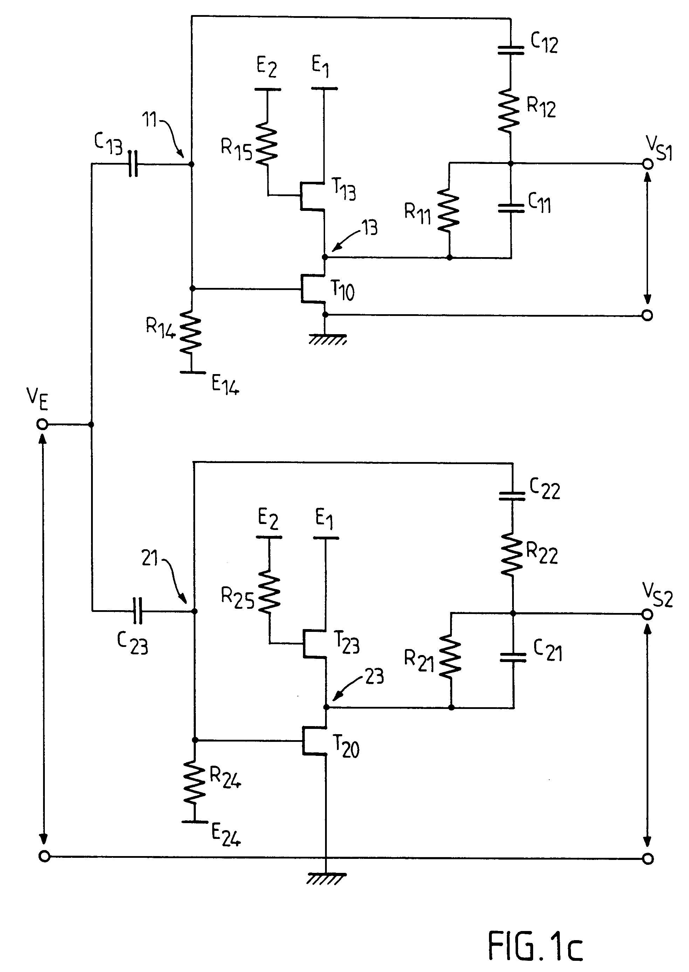

Selon l'invention, on peut utiliser des cellules du type de celles qui ont été décrites et illustrées par les figures 1 et 2, c'est-à-dire telles que $\omega'_1 = \omega'_0$, $\omega''_1 = \omega''_0$, $Q'_1 = -Q'_0$ et $Q''_1 = -Q''_0$ (voir les relations 3ter et 3ter du tableau I. On choisit alors des cellules ayant même gain $G_1 = G_2$ (relation 10 du tableau I).

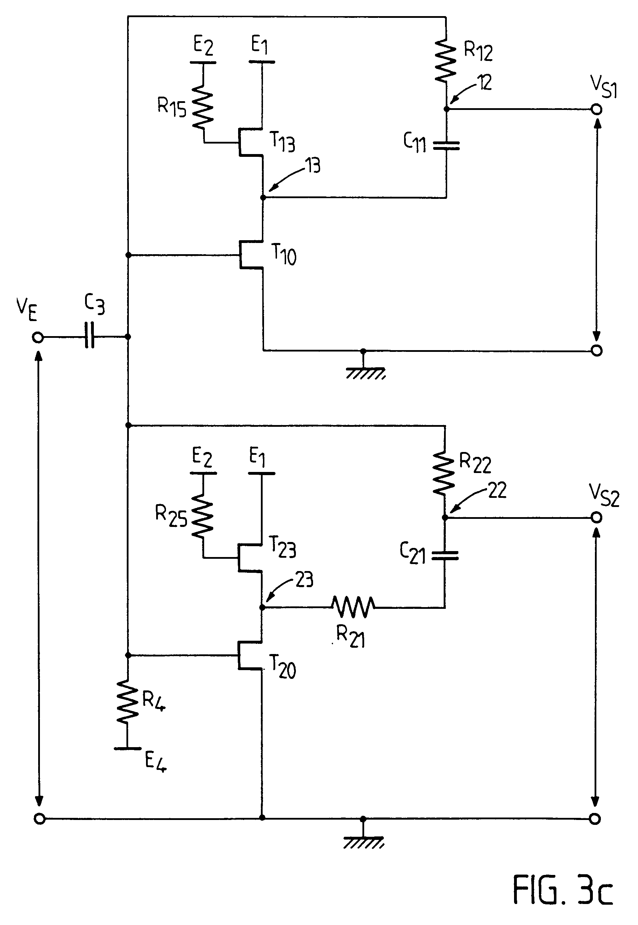

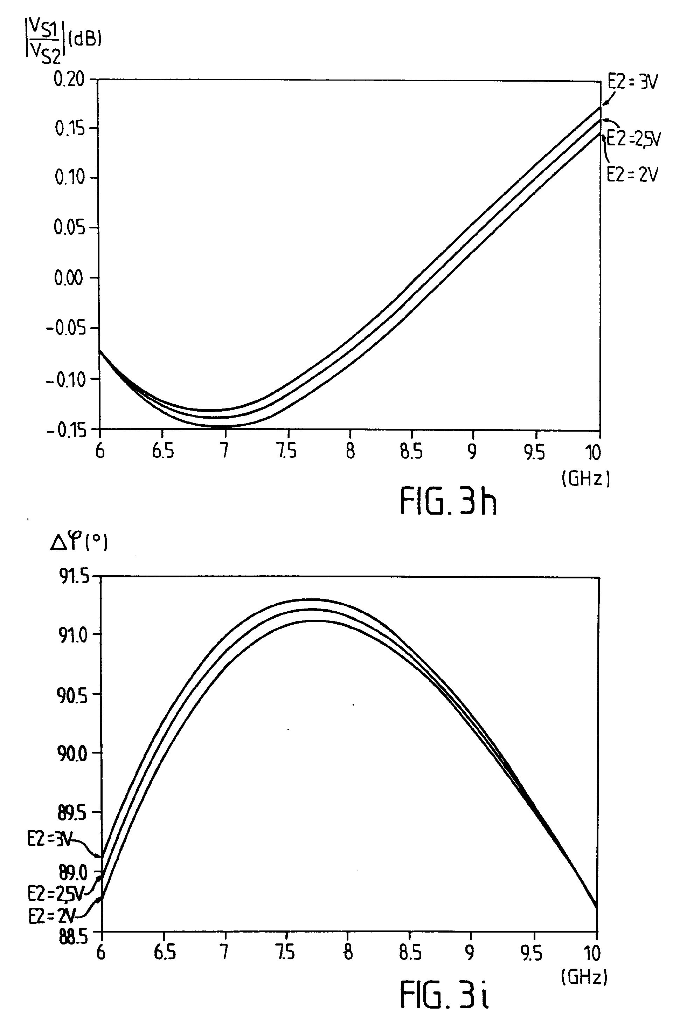

Selon l'invention on peut aussi utiliser pour constituer les cellules $B_1$ et $B_2$ des cellules pseudo-passe-tout telles qu'illustré par les figures 3.

Alors, comme précédemment la phase de chaque cellules $B_1$ et $B_2$ varie de 0 à $-2\pi$ quand $\omega$ varie de 0 à $\infty$, et la différence de phase peut être rendue voisine de 90° dans une bande de fréquences données. Par contre le gain n'est plus indépendant de la fréquence. Cette variation du gain n'est pas gênante, le point qui importe est que le rapport des gains des deux cellules reste très voisin de 1 dans la bande l'utilisation du déphaseur. Ce résultat peut être obtenu par un choix approprié des paramètres $\omega_1$, $\omega_0$, $Q_1$, $Q_0$ et $G$ pour chaque cellule.

La mise en oeuvre d'un déphaseur 0-90° au moyen de cellules tel qu'illustré par la figure 1b est donnée sur la figure 1c et les éléments pour réaliser ce circuit sont donnés dans le tableau III.

La figure 2c illustre un déphaseur 0-90° actif réalisé au moyen de deux cellules $B_1$ et $B_2$ telles que montré à la figure 2b, les éléments pour mettre en oeuvre le circuit de la figure 2c sont rassemblés dans le tableau V.

Enfin un déphaseur 0-90° actif réalisé au moyen de deux cellules illustrées par la figure 3b est montré sur la figure 3c et les éléments pour réaliser le circuit de la figure 3c sont rassemblés dans le tableau VII.

Comme on l'a dit précédemment le circuit déphaseur de la figure 1c fonctionnera dans la bande de fréquences inférieures à 1 GHz, le déphaseur de la figure 2c fonctionnera dans la bande de fréquences de 1 à 9 GHz et le circuit déphaseur de la figure 3c dans la bande de fréquences supérieures à 9 GHz.

Pour les applications hyperfréquences, le montage de la figure 3c est donc le plus intéressant. On rappelle que pour ces cellules, un des pôles utilisé dans la fonction de transfert est dû à la coupure de l'amplificateur, ce qui permet de monter haut en fréquence mais les rend moins bien appropriées aux applications basses fréquences. C'est pourquoi trois formes de circuits ont été proposées.

En ce qui concerne le circuit de la figure 3c, ces caractéristiques sont données sur les courbes dans le cas où un condensateur de 50 fF est placé sur chacune de ses sorties, représentant l'impédance d'entrée des montages chargeant le déphaseur, qui peuvent être par exemple des suiveurs du type donné sur la figure 5.

Les valeurs du tableau VII ne sont données qu'à titre d'exemple. Une modification de ces valeurs permet de modifier la bande d'utilisation du déphaseur si nécessaire.

Un autre choix des valeurs peut aussi permettre d'améliorer les performances du déphaseur : l'utilisation de passe-tout d'ordre 2 confère au montage de nombreux degrés de liberté, et l'optimisation des valeurs des éléments est à étudier dans chaque cas particulier. Afin d'ajuster au mieux les caractéristiques on peut aussi jouer sur les sources de tension $E_2$, $E_4$, et éventuellement polariser les grilles des transistors amplificateurs $T_{10}$ et $T_{20}$ par deux tensions de polarisation différentes.

Avec les valeurs du tableau VII, les caractéristiques du circuit de la figure 3c sont très intéressantes :
- l'écart de phase $\Delta\varphi = \varphi V_{S1} - \varphi V_{S2}$ entre les deux sorties ne dépasse pas sa valeur théorique 90° de plus de 1,25° (voir la figure 3e) ;

- la bande d'utilisation du déphaseur, dans laquelle $\Delta\varphi$ est compris entre 89° et 91°,25 est très large et située très haut en fréquence, elle va de 6 GHz à 9,8 GHz (voir la figure 3e) ;
- l'écart de gain entre les sorties $V_{S1}/V_{S2}$ s'écarte de moins de 0,15 dB de sa valeur théorique 0 dB dans toute la bande (voir la figure 3f) ;
- les pertes du déphaseur, c'est-à-dire $V_{S1}/V_2$ et $V_{S2}/V_E$, sont relativement faibles, c'est-à-dire environ équivalentes à -1,6 dB (voir la figure 3g).

Un réglage très fin des caractéristiques peut être obtenu en ajustant la tension de polarisation $E_2$ :

- Réglage de $\Delta\varphi$ :
  en ajustant la tension de polarisation $E_2$, le gain des deux cellules $B_1$ et $B_2$ varie faiblement et dans les mêmes proportions, donc l'écart de gain n'est pas altéré (voir la figure 3h). On peut ainsi ajuster $\Delta\varphi$. Ce réglage est très fin : si $E_2$ varie de 1 V, alors $\Delta\varphi$ maximal varie de 0,25° (voir la figure 3i).
- Réglage de l'écart de gain :
  on n'envoit plus ici la même polarisation $E_2$ sur les transistors $T_{13}$ et $T_{23}$. On ne relie plus $R_{15}$ et $R_{25}$ entre elles mais on peut remplacer $E_2$ par une tension de polarisation $E_{21}$ reliée à $R_{15}$ et par une tension de polarisation $E_{22}$ reliée à $R_{25}$. Alors en laissant la tension de polarisation $E_{22}$ à sa valeur nominale 2,5 V (voir tableau VII) et en jouant sur la tension de polarisation $E_{21}$, on ne modifie quasiment pas la différence de phase $\Delta\varphi$ (voir la figure 3j) mais on règle l'écart de gain (voir la figure 3k). Ce réglage est très fin pour une variation de $E_{21}$ de 1 V, l'écart de gain varie de moins de 0,1 dB. On remarquera que l'on utilise $E_{21}$ plutôt que $E_{22}$ car $E_{22}$ joue un peu sur la différence de phase $\Delta\varphi$. Les résultats précédents ont été obtenus avec des transistors à effet de champ en arséniure de gallium dits MESFET. Mais des performances encore meilleures peuvent être obtenues avec des transistors à effet de champ du type HEMT.

Concernant les déphaseurs montrés sur les figures 1c et 2c qui fonctionnent à des fréquences plus basses, on peut également fusionner les tensions d'alimentation $E_{24}$ et $E_{14}$, les résistances $R_{24}$ et $R_{14}$ et les capacités $C_{13}$ et $C_{23}$. Des mesures ont été réalisées en chargeant les sorties par une capacité $C_L = 50$ fF comme précédemment ; on a obtenu :

- l'écart de phase $\Delta\varphi$ : il s'écarte au plus de 1 degré da sa valeur théorique 90° dans la bande d'utilisation (voir la figure 2e) ;
- la bande où $\Delta\varphi$ est compris entre 89° et 91° va d'environ 1,9 GHz à 2,95 GHz (voir la figure 2e) ;
- l'écart entre les gains varie de 0,035 dB dans la bande et reste inférieur à 0,07 dB dans la bande (voir la figure 2f) ;
- le gain des cellules $B_1$ et $B_2$ est proche de 0 dB (conformément à leurs équations $G_1 = G_2 = 1$).

Les circuits selon l'invention peuvent être réalisés sur l'arséniure de gallium comme il a été dit précédemment, mais aussi sur tout autre matériau semiconducteur par exemple le silicium.

## TABLEAU I

Fonction de transfert générale du filtre :

$$G(s) = G. \frac{(s/\omega_1)^2 + (1/Q_1)\ (s/\omega_1) + 1}{(s/\omega_0)^2 + (1/Q_0)\ (s/\omega_0) + 1} \quad (1)$$

Fonction coupe-bande

$$1/Q_1 = 0 \quad\quad (2) \quad\quad\quad et \quad\quad \omega_1 = \omega_0 \quad\quad (3)$$

Fonction passe-tout

$$Q_1 = -Q_0 \quad\quad (2bis) \quad\quad et \quad\quad \omega_1 = \omega_0 \quad\quad (6bis)$$

Filtre de la figure 1a :

Gain de l'amplificateur A :

$$H(S) = -k \text{ où } k \text{ est une constante} \quad (4)$$

$$G \quad = -k \quad (5)$$

$$\omega_1 = \omega_0 = 1/(R_1\ C_1\ R_2\ C_2)^{\frac{1}{2}} \quad (6)$$

$$Q_1 = (R_1\ C_1\ R_2\ C_2)^{\frac{1}{2}}/[(R_1 C_1 + R_2 C_2) - \frac{R_1 C_2}{k}] \quad (7)$$

$$Q_0 = (R_1\ C_1\ R_2\ C_2)^{\frac{1}{2}}/(R_1 C_1 + R_2 C_2 + R_1 C_2) \quad (8)$$

Si $R_1 = R_2$ et $C_1 = C_2$ alors

$k = 0,5$ en coupe-bande

$k = 0,2$ en passe-tout

la fréquence caractéristique du filtre est $f_0 = \omega_0/2\pi$

Filtre de la figure 2a

Gain de l'amplificateur A

$$H(S) = -k \quad\quad\quad (4bis)$$

$$G \quad = 1 \quad\quad\quad (5bis)$$

$$\omega_1 = \omega_0 = 1/(R_1 C_1\ R_2\ C_2)^{\frac{1}{2}} \quad (6bis)$$

$$Q_1 = (R_1\ C_1\ R_2\ C_2)^{\frac{1}{2}}/(R_1\ C_1 + R_2\ C_2 - kR_2\ C_1) \quad (7bis)$$

$$Q_0 = (R_1\ C_1\ R_2\ C_2)^{\frac{1}{2}}/(R_1\ C_1 + R_2\ C_2 + R_2\ C_1) \quad (8bis)$$

Si $R_1 = R_2$ et $C_1 = C_2$ alors

$k = 2$ en coupe-bande

$k = 5$ en passe-tout

la fréquence caractéristique du filtre est

$$f_0 = \omega_0/2\pi$$

## TABLEAU I (Suite)

#### Filtre de la figure 3a

Le gain de l'amplificateur A est donné par

$$H(s) = -k/(\tau.s+1) \qquad (4ter)$$

où $\tau = 1/\omega_p$    $\omega_p$ étant la pulsation de coupure de l'amplificateur

$$G = 1 \qquad (5ter)$$

$$\omega_0 = 1/[(R_1+R_2)C_1 \tau]^{\frac{1}{2}} \qquad (6ter)$$

$$\omega_1 = 1/(R_1 C_1 \tau)^{\frac{1}{2}} \qquad (6quater)$$

$$Q_1 = (R_1 C_1 \tau)^{\frac{1}{2}}/(R_1 C_1 + \tau - R_2 C_1 k) \qquad (7ter)$$

$$Q_0 = [(R_1 + R_2)C_1 \tau]^{\frac{1}{2}} / [(R_1+R_2)C_1 + \tau] \qquad (8ter)$$

Fonction de transfert du circuit déphaseur de la figure 4 réalisée au moyen de deux filtres passe-tout selon l'une des figures 1, 2 Ou 3.

(1bis) Pour la cellule $B_1$   $G_1(s) = G_1.\dfrac{(s/\omega'_1)^2+(1/Q'_1)(s/\omega'_1)+}{(s/\omega'_0)^2+(1/Q'_0)(s/\omega'_0)+1}$

(1ter) Pour la cellule $B_2$   $G_2(s) = G_2.\dfrac{(s/\omega''_1)^2+(1/Q''_1)(s/\omega''_1)+}{(s/\omega''_0)^2+(1/Q''_0)(s/\omega''_0)+}$

$$(3ter) \begin{cases} \omega'_1 = \omega'_0 \\ \\ \omega''_1 = \omega''_0 \end{cases} \begin{cases} Q'_1 = -Q'_0 \\ \qquad\qquad (2ter) \\ Q''_1 = -Q''_0 \end{cases}$$

$$et \ G_1 = G_2 \qquad (10)$$

la fréquence de coupure de l'amplificateur est

$$f_p = \omega_p/2\pi$$

| TABLEAU II |
| --- |
| ===================================================== |
| Eléments pour mettre en oeuvre le circuit de la figure 1b dans l'exemple |
| Largeur de grille des transistors $T_0$ : $W_0$ = 200 µm<br>$T_1$ : $W_1$ = 20 µm<br>$T_2$ : $W_2$ = 20 µm<br>$T_3$ : $W_3$ = 100 µm |
| Valeurs des résistances $\qquad$ $R_3$ = 10 kΩ<br>$R_4$ = 10 kΩ<br>$R_5$ = 140 Ω |
| Valeurs des capacités $\qquad$ $C_1$ = 0,1 pF<br>$C_2$ = 0,1 pF |
| Valeur des tensions de polarisation et d'alimentation continues $\qquad$ $E_1$ = +6 V<br>$E_2$ = +2,5 V<br>-1,8 V $<$ $E_3$ $-V_3$ $<$ 0V pour le réglage de $\omega_1$<br>-2 V $\quad$ $<$ $E_4$ $<$ -0,75 V pour le réglage de k |

<div style="border:1px solid">

**TABLEAU III**

==============================================================

Eléments pour mettre en oeuvre le circuit de la figure 1c
dans l'exemple

---

Largeur de grille des transistors $T_0$ : $W_0$ = 200 μm

$T_1$ : $W_1$ = 20 μm

$T_2$ : $W_2$ = 20 μm

$T_3$ : $W_3$ = 100 μm

---

Valeurs des résistances $R_{12} \simeq$ 500 $\Omega$ $R_{22} \simeq$ 1500 $\Omega$

$R_{15} \simeq$ 800 $\Omega$ $R_{25} \simeq$ 3800 $\Omega$

$R_{14}$ = 10 k$\Omega$ $R_{24} \simeq$ 10 k$\Omega$

---

Valeurs des capacités $C_1$ = 0,2 pF

$C_2$ = 0,2 pF

---

Valeur des tensions de polarisation et d'alimentation
continues $E_1$ = +6 V

$E_2$ = +2,5 V

1,8 V $\triangleleft$ $E_3$ -$V_3$ $\triangleleft$ 0V pour le réglage de $\omega_1$

-2 V $\triangleleft$ $E_4$ $\triangleleft$ -0,75 V pour le réglage de k

</div>

<div style="border:1px solid">

**TABLEAU IV**

=====================================================

Eléments pour mettre en oeuvre le circuit de la figure 2b dans l'exemple

---

Largeur de grille du transistor $T_0$ : $W_0$ = 200 µm

$T_2$ : $W_2$ = 20 µm

$T_3$ : $W_3$ = 100 µm

---

Valeurs des résistances $\qquad$ $R_3$ = 10 kΩ

$R_4$ = 10 kΩ

$R_5$ = 140 Ω

---

Valeurs des tensions d'alimentation et de polarisation continues $\qquad$ $E_1$ = + 6V

$E_2$ = +2,5 V

$-1,8$ V < $E_3 - V_3$ < 0 V pour le réglage de $\omega_1$

$-2,0$ V < $E_4$ < $-0,75$ V pour le réglage de k

---

Valeurs des capacités $\qquad$ $C_1$ = 0,1 pF

$C_2$ = 0,1 pF

</div>

## TABLEAU V

===================================================================

Eléments pour mettre en oeuvre le circuit de la figure 2c dans l'exemple

Largeur de grille du transistor $T_{10}$ et $T_{20}$ : $W_{10}$ = 200 µm

Largeur "          "          "     " $T_{13}$ et $T_{23}$ : $W_{13}$ = 100 µm

Valeurs des résistances          $R_{12}$ = 450 $\Omega$   $R_{22}$ = 1480 $\Omega$

$R_{15}$ = 730 $\Omega$   $R_{25}$ = 3600 $\Omega$

$R_{14}$ = 10 k$\Omega$   $R_{24}$ = 10 k$\Omega$

Valeurs des capacités          $C_{11}$ = 0,1 pF   $C_{21}$ = 0,1 pF

$C_{12}$ = 0,1 pF   $C_{22}$ = 0,1 pF

$C_{13}$ = $C_{23}$ = 5 pF

Niveau des alimentations et polarisations          $E_1$ = + 6V

continues          $E_2$ = +2,5V

$E_{14}$ = -0,8V

$E_{24}$ = -1,6V

**TABLEAU VI**

==================================================================

Eléments pour mettre en oeuvre le circuit de la figure 3b
dans l'exemple

Largeur de grille des transistors $T_0$ : $W_0$ = 200 µm

$T_2$ : $W_2$ = 20 µm

$T_3$ : $W_3$ = 100 µm

Valeurs des résistances $R_3$ = 10 k$\Omega$

$R_4$ = 10 k$\Omega$

$R_5$ = 35 $\Omega$

Valeurs des capacités $C_1$ = 0,1 pF

Valeur des tensions de polarisation et d'alimentation
continues $E_1$ = +6V

$E_2$ = +2,5V

$-0,95V < E_3 - V_3 < 0V$ pour le réglage de $\omega_1$

$-2V < E_4 < -0,875V$ pour le réglage de k

EP 0 398 442 B1

```
                  TABLEAU VII

========================================================

Eléments pour mettre en oeuvre le circuit de la figure 3c
dans l'exemple
```

Largeur de grille du transistor $T_{10}$, $T_{20}$ : $W_{10} = 150$ µm
Largeur "       "       "    "  $T_{13}$, $T_{23}$ : $W_{13} = 75$  µm

Valeurs des résistances    $R_{12} = 270$ Ω   $R_{22} = 485$ Ω
                           $R_{15} = 250$ Ω   $R_{25} = 760$ Ω
                           $R_{21} = 410$ Ω
                           $R_4 = 10$ kΩ

Valeurs des capacités    $C_{11} = 0,1$ pF   $C_{21} = 0,24$ pF
                         $C_3 = 10$ pF

Niveau des alimentations et polarisations   $E_1 = + 6V$
continues                                   $E_2 = +2,5V$
                                            $E_4 = -0,9V$

## Revendications

1. Dispositif semiconducteur incluant un filtre actif dans le domaine des hautes et hyperfréquences, ce filtre présentant une entrée et une sortie asymétriques, référencées par rapport à la masse, comportant entre cette entrée et cette sortie :
   - une première branche comprenant un amplificateur de fonction de transfert H(s) et une première impédance $Z_1$ en série,
   - une seconde branche comprenant une seconde impédance $Z_2$,
   caractérisé en ce que :
   - le circuit amplificateur de la première branche est choisi entre un circuit amplificateur ayant une fonction de transfert H(S) d'ordre 0, et un circuit amplificateur ayant une fonction de transfert H(s) PASS-BAS d'ordre 1, pour fixer la gamme de fréquences de fonctionnement du filtre actif ;
   - le gain basse fréquence de la fonction de transfert H(S) du circuit amplificateur de la première branche est contrôlé par des moyens de réglage appliqués à ce circuit qui agissent en coopération avec la valeur et la configuration des impédances $Z_1$ et $Z_2$ pour ajuster les caractéristiques du filtre actif, dans ladite gamme de fréquences de fonctionnement, entre les caractéristiques de filtre coupe-bande et celles de filtre passe-tout ;
   - la fonction de transfert de filtre actif est d'ordre 2.

2. Circuit selon la revendication 1, caractérisé en ce que les moyens de réglage sont choisis entre une tension de polarisation ajustable appliquée au circuit amplificateur de la première branche et une charge ajustable.

3. Dispositif selon l'une des revendications 1 ou 2, caractérisé en ce que :

17

- le circuit amplificateur a une fonction de transfert H(s) d'ordre 0 ;
- les impédances $Z_1$ et $Z_2$ comportent chacune une résistance et une capacité, respectivement $R_1$, $C_1$ et $R_2$, $C_2$ ;
- et pour fixer la gamme de fréquences de fonctionnement du filtre actif, la configuration des impédances est choisie entre : filtre $R_1C_1$ parallèle pour l'impédance $Z_1$ coopérant avec un filtre $R_2C_2$ série pour l'impédance $Z_2$, et un filtre $R_1,C_1$ série pour l'impédance $Z_1$ coopérant avec un filtre $R_2C_2$ parallèle pour l'impédance $Z_2$, la fréquence caractéristique du filtre actif étant

$$f_0 = 1/(2\pi \sqrt{R_1C_1R_2C_2}).$$

4. Dispositif selon la revendication 3, caractérisé en ce que les moyens de réglage appliqués à l'amplificateur fixe la gamme de fréquences autour de 1 GHz et en ce que la configuration de l'impédance $Z_1$ est un filtre $R_1C_1$ parallèle et la configuration de l'impédance $Z_2$ est un filtre $R_2C_2$ série.

5. Dispositif selon la revendication 3, caractérisé en ce que les moyens de réglage appliqués à l'amplificateur fixe la gamme de fréquences entre environ 1 GHz et environ 10 GHz et en ce que la configuration de l'impédance $Z_1$ est un filtre $R_1C_1$ série et la configuration de l'impédance $Z_2$ est un filtre $R_2C_2$ parallèle.

6. Dispositif selon l'une des revendications 1 ou 2, caractérisé en ce que :
   - le circuit amplificateur a une fonction de transfert H(s) d'ordre 1 ;
   - la configuration de l'impédance $Z_1$ en série avec l'amplificateur dans la première branche est un filtre formé d'une résistance $R_1$ et d'une capacité $C_1$ en série ;
   - la configuration de l'impédance $Z_2$ dans la seconde branche est une résistance $R_2$ ;
   - le circuit amplificateur est placé dans des conditions requises pour fonctionner autour de sa fréquence de coupure supposée différente de l'infini.

7. Dispositif selon l'une des revendications précédentes, caractérisé en ce que la fonction de transfert du filtre actif a pour expression :

$$G(s) = G.\frac{(s/\omega_1)^2 + (1/Q_1)(s/\omega_1) + 1}{(s/\omega_0)^2 + (1/Q_0)(s/\omega_0) + 1}$$

expression dans laquelle :
   G est le gain total du filtre,
   s est la variable de Laplace,
   $\omega_1$ est la pulsation associée aux zéros de G(s),
   $\omega_0$ est la pulsation associée aux pôles de G(s),
   $Q_0$ est la sélectivité ou facteur de qualité du filtre,
   $Q_1$ est le facteur de réjection du filtre.

8. Dispositif selon la revendication 7 dans la mesure où cette dernière dépend de l'une des revendications 3 à 5, caractérisé en ce que les résistances $R_1$ et $R_2$ des impédances $Z_1$ et $Z_2$ sont égales ($R_1 = R_2$), et en ce que les capacités $C_1$ et $C_2$ des impédances $Z_1$ et $Z_2$ sont égales ($C_1 = C_2$).

9. Dispositif selon la revendication 8, dans la mesure où elle dépend de la revendication 4, caractérisé en ce que le gain de l'amplificateur défini par H(s) est constant sur toute la bande de fréquences de fonctionnement fixée pour le filtre actif, et est choisi compris entre les valeurs :
   H(s) = -0,5 qui produit la fonction coupe-bande $(1/Q_1) = 0$ pour le filtre actif,
   et H(s) = -0,2 qui produit la fonction passe-tout $Q_1 = -Q_0$ pour le filtre actif, de manière que ;
   $- 0,2 \leqq H(s) \leqq - 0,5.$

10. Dispositif selon la revendication 6, dans la mesure où elle dépend de la revendication 5, caractérisé en ce que le gain de l'amplificateur défini par H(s) est constant sur toute la bande de fréquences de fonctionnement fixée pour le filtre actif, et est choisi compris entre les valeurs
    H(s) = -2 qui produit la fonction coupe-bande pour le filtre actif $(1/Q_1 = 0)$
    H(s) = -5 qui produit la fonction passe-tout pour le filtre actif $Q_1 = -Q_0$, de manière que :
    $- 5 \leqq H(s) \leqq - 2.$

11. Dispositif selon la revendication 7, dans la mesure où elle dépend de la revendication 6, caractérisé en ce que le gain non constant du circuit amplificateur est défini par :

$$H(s) = -k/(\tau \cdot 2\pi \cdot f_p + 1)$$

où :

$f_p$ est la fréquence de coupure de l'amplificateur,

$\tau$ est la constante de Laplace,

et en ce que dans les impédances $Z_1$ et $Z_2$ les valeurs des résistances sont égales ($R_1 = R_2$) et la valeur de la capacité $C_1$ dans l'impédance $Z_1$ est donnée par $(C_1/R_1) = 2\pi f_p$.

12. Dispositif selon la revendication 11,
caractérisé en ce que, pour passer de la fonction coupe-bande ($1/Q_1 \simeq 0$) à la fonction passe-tout ($Q_1 \simeq -Q_0$), avec $\omega_1 \simeq \omega_0$, le gain de l'amplificateur (H(S)) conduit de :
k = 2 (fonction coupe-bande) à

$$k = 2 + \frac{3}{\sqrt{2}} \simeq 4,1$$

(fonction passe-tout)

13. Dispositif selon l'une des revendications 9, 10 ou 12, caractérisé en ce que l'amplificateur est constitué d'un premier transistor $T_0$ relié à une alimentation continue positive $E_1$ à travers un transistor de charge $T_3$ dont la grille est polarisée à travers une résistance $R_5$ par une tension continue positive $E_2$, la grille du transistor amplificateur $T_0$ qui reçoit le signal d'entrée $V_E$, étant en outre polarisée à travers une résistance $R_4$ par une tension continue négative $E_4$ au moyen de laquelle la constante -k du gain de l'amplificateur est réglée.

14. Dispositif selon la revendication 13, caractérisé en ce que la résistance $R_2$ incluse dans l'impédance $Z_2$ de la seconde branche est constituée par un transistor $T_2$ dont la grille est polarisée à travers une résistance $R_3$ par une tension continue négative par rapport à la polarisation de la source de ce transistor $T_2$ au moyen de laquelle $\omega_1$ est ajustée.

15. Dispositif selon la revendication 14, dans la mesure où elle dépend de la revendication 9, caractérisé en ce que la résistance $R_1$ incluse dans l'impédance $Z_1$ de la branche principale est constituée par un transistor $T_1$ dont le drain est relié directement à la source du transistor $T_2$ de la seconde branche jouant le rôle de résistance $R_2$ de l'impédance $Z_2$, et dont la grille est reliée à la grille de ce transistor $T_2$ pour être polarisée de façon identique.

16. Dispositif selon l'une des revendications précédentes, caractérisé en ce que le filtre est réglé en coupe-bande.

17. Dispositif selon la revendication 16, caractérisé en ce que le filtre réglé en coupe-bande est appliqué à former un circuit réjecteur de fréquences.

18. Dispositif selon l'une des revendications 1 à 15, caractérisé en ce que le filtre est réglé en passe-tout.

19. Dispositif selon la revendication 18, caractérisé en ce que deux filtres réglés en passe-tout sont associés de manière à recevoir le même signal d'entrée et à fournir chacun un signal de sortie déphasé de 90° pour former un circuit déphaseur.

**Patentansprüche**

1. Halbleiteranordnung mit einem aktiven Filter im hohen und ultrahohen Frequenzgebiet, wobei dieses Filter je einen auf Masse bezogenen asymmetrischen Ein- und Ausgang besitzt und zwischen diesem Ein- und Ausgang folgendes umfaßt:
   - Einen ersten Zweig mit einem Verstärker mit Übertragungsfunktion H(s) und einer ersten reihengeschalteten Impedanz $Z_1$,
   - einen zweiten Zweig mit einer zweiten Impedanz $Z_2$
     dadurch gekennzeichnet, daß
   - die Verstärkerschaltung des ersten Zweigs so gewählt ist, daß sie zwischen einer Verstärkerschaltung mit einer Übertragungsfunktion H(s) 0. Ordnung und einer Verstärkerschaltung mit einer TIEFPASS-Übertragungsfunktion H(s) 1. Ordnung liegt, um den Arbeitsfrequenzbereich des Aktivfilters festzulegen;

- die Niederfrequenzverstärkung der Übertragungsfunktion H(S) der Verstärkerschaltung des ersten Zweigs durch Einstellteile gesteuert ist, die in diese Schaltung eingebaut sind und die mit dem Wert und der Konfiguration der Impedanzen $Z_1$ und $Z_2$ zusammenwirken, um die Kennwerte des Aktivfilters im genannten Arbeitsfrequenzbereich zwischen den Kennwerten des Bandsperrfilters und denen des Durchgangsfilters zu regulieren;
- die Übertragungsfunktion des aktiven Filters 2. Ordnung ist.

2. Schaltung nach Anspruch 1, dadurch gekennzeichnet, daß die Einstellteile ausgewählt werden aus einer auf die Verstärkerschaltung des ersten Zweigs wirkenden einstellbaren Polarisationsspannung und einer einstellbaren Last.

3. Schaltung nach einem der Ansprüche 1 oder 2, dadurch gekennzeichnet, daß
  - die Verstärkerschaltung eine Übertragungsfunktion H(s) 0. Ordnung hat;
  - die Impedanzen $Z_1$ und $Z_2$ jeweils einen Widerstand und ein C-Glied $R_1$, $C_1$ bzw. $R_2$, $C_2$ umfassen;
  - und zur Festlegung des Arbeitsfrequenzbereichs des aktiven Filters die Konfiguration der Impedanzen ausgewählt ist aus einem parallelgeschalteten Filter $R_1C_1$ für die Impedanz $Z_1$, das mit einem reihengeschalteten Filter $R_2C_2$ für die Impedanz $Z_2$ zusammenwirkt, und einem reihengeschalteten Filter $R_1C_1$ für die Impedanz $Z_1$, die mit einem parallelgeschalteten Filter $R_2C_2$ für die Impedanz $Z_2$ zusammenwirkt, wobei die charakteristische Frequenz des aktiven Filters

$$F_0 = 1/(2\pi\sqrt{R_1C_1R_2C_2})$$

ist.

4. Anordnung nach Anspruch 3, dadurch gekennzeichnet, daß die auf den Verstärker wirkenden Einstellteile den Frequenzbereich auf ungefähr 1 Ghz festlegen und daß die Konfiguration der Impedanz $Z_1$ ein parallelgeschaltetes Filter $R_1C_1$ und die Konfiguration der Impedanz $Z_2$ ein reihengeschaltetes Filter $R_2C_2$ ist.

5. Anordnung nach Anspruch 3, dadurch gekennzeichnet, daß die auf den Verstärker wirkenden Einstellteile den Frequenzbereich zwischen ungefähr 1 GHz und ungefähr 10 GHz festlegen und daß die Konfiguration der Impedanz $Z_1$ ein reihengeschaltetes Filter $R_1C_1$ und die Konfiguration der Impedanz $Z_2$ ein parallelgeschaltetes Filter $R_2C_2$ ist.

6. Anordnung nach einem der Ansprüche 1 oder 2, dadurch gekennzeichnet, daß
  - die Verstärkerschaltung ein Übertragungsfunktion H(s) 1. Ordnung hat;
  - die Konfiguration der mit dem Verstärker im ersten Zweig reihengeschalteten Impedanz $Z_1$ ein Filter aus einem reihengeschalteten Widerstand $R_1$ und einem C-Glied $C_1$ ist;
  - die Konfiguration der Impedanz $Z_2$ im zweiten Zweig ein Widerstand $R_2$ ist;
  - die Verstärkerschaltung in die Lage versetzt wird, um im Bereich um ihre Sperrfrequenz herum zu arbeiten, wobei angenommen wird, daß diese Sperrfrequenz nicht gleich unendlich ist.

7. Anordnung nach einem der v orstehenden Ansprüche, dadurch gekennzeichnet, daß die Übertragungsfunktion des aktiven Filters folgender Gleichung entspricht:

$$G(s) = G\cdot\frac{(s/\omega 1)2 + (1/Q1) + 1}{(s/\omega 0)2 + (1/Q0)(s/\omega 0) + 1}$$

wobei

G die Gesamtverstärkung des Filters
s die Laplace-Variable
$\omega_1$ die zu den Nullpunkten von G(s) gehörende Pulsation
$\omega_0$ die zu den Polen von G(s) gehörende Pulsation
$Q_0$ die Trennschärfe oder der Qualitätsfaktor des Filters
$Q_1$ der Unterdrückungsfaktor des Filters ist.

8. Anordnung nach Anspruch 7, in dem Maße, wie dieser von einem der Ansprüche 3 bis 5 abhängig ist, dadurch gekennzeichnet, daß die Widerstände $R_1$ und $R_2$ der Impedanzen $Z_1$ und $Z_2$ gleich sind ($R_1 = R_2$) und daß die C-Glieder $C_1$ und $C_2$ der Impedanzen $Z_1$ und $Z_2$ gleich sind ($C_1 = C_2$).

9. Anordnung nach Anspruch 8, in dem Maße, wie dieser von Anspruch 4 abhängig ist, dadurch gekennzeichnet, daß die durch H(s) definierte Verstärkung des Verstärkers über das gesamte Arbeitsfrequenzband des aktiven Filters hinweg konstant ist und zwischen folgenden Werten liegt:

H(s) = -0,5 für die Bandsperrfunktion $(1/Q_1) = 0$ für das aktive Filter,

und H(s) = -0,2 für die Durchgangsfunktion $Q_1 = -Q_0$ für das aktive Filter, so daß

$$- 0,2 \leqq H(s) \leqq - 0,5.$$

10. Anordnung nach Anspruch 6, in dem Maße, wie dieser von Anspruch 5 abhängig ist, dadurch gekennzeichnet, daß die durch H(s) definierte Verstärkung des Verstärkers über das gesamte Arbeitsfrequenzband des aktiven Filters hinweg konstant ist und zwischen folgenden Werten liegt:

H(s) = -2 für die Bandsperrfunktion für das aktive Filter $(1/Q_1) = 0$,

und H(s) = -5 für die Durchgangsfunktion für das aktive Filter $Q_1 = - Q_0$, so daß

$$- 5 \leqq H(s) \leqq - 2.$$

11. Anordnung nach Anspruch 7, in dem Maße, wie dieser von Anspruch 6 abhängig ist, dadurch gekennzeichnet, daß die nicht konstante Verstärkung der Verstärkerschaltung folgendermaßen definiert ist:

$$H(s) = - k/(\tau . 2\pi . f_p + 1),$$

wobei

$f_p$ die Sperrfrequenz des Verstärkers und

$\tau$ die Laplace-Konstante ist, und daß bei den Impedanzen $Z_1$ und $Z_2$ die Widerstandswerte gleich sind $(R_1 = R_2)$ und sich der Wert des C-Glieds $C_1$ in der Impedanz $Z_1$ aus der Gleichung $(C_1/R_1) = 2\pi f_p$ ergibt.

12. Anordnung nach Anspruch 11, dadurch gekennzeichnet, daß beim Übergang von der Bandsperrfunktion $(1/Q_1 \approx 0)$ zur Durchgangsfunktion $(Q_1 \approx -Q_0)$ mit $\omega_1 \approx \omega_0$ die Verstärkung (H(s)) von

k = 2 (Bandsperrfunktion) nach

$$k = 2 + 3/\sqrt{2} \approx 4,1$$

(Durchgangsfunktion) geht.

13. Anordnung nach einem der Ansprüche 9, 10 oder 12, dadurch gekennzeichnet, daß der Verstärker aus einem ersten Transistor $T_0$ besteht, der über einen Lasttransistor $T_3$, dessen Gate-Elektrode über einen Widerstand $R_5$ durch eine positive Dauerspannung $E_2$ polarisiert ist, mit einer positiven Dauerversorgung $E_1$ verbunden ist, wobei die Gate-Elektrode des Verstärkertransistors $T_0$ das Eingangssignal $V_E$ erhält und im übrigen über einen Widerstand $R_4$ durch eine negative Dauerspannung $E_4$ polarisiert ist, mit Hilfe der die Konstante -k der Verstärkung geregelt wird.

14. Anordnung nach Anspruch 13, dadurch gekennzeichnet, daß der in die Gegenkopplungsimpedanz $Z_2$ integrierte Widerstand $R_2$ aus einem Transistor $T_2$ besteht, dessen Gate-Elektrode über einen Widerstand $R_3$ durch eine im Vergleich zur Polarisation der Source dieses Transistors $T_2$ negative Dauerspannung polarisiert ist, mit Hilfe der $\omega_1$ geregelt wird.

15. Anordnung nach Anspruch 14, in dem Maße, wie dieser von Anspruch 9 abhängig ist, dadurch gekennzeichnet, daß der in die Impedanz $Z_1$ des Hauptzweigs integrierte Widerstand $R_1$ aus einem Transistor $T_1$ besteht, dessen Drain-Anschluß direkt mit der Source des Transistors $T_2$ des zweiten Zweigs verbunden ist, die in der Impedanz $Z_2$ die Rolle des Widerstands $R_2$ spielt, und dessen Gate-Elektrode an die Gate-Elektrode dieses Transistors $T_2$ angeschlossen ist, damit eine identische Polarisation entsteht.

16. Anordnung nach einem der vorstehenden Ansprüche, dadurch gekennzeichnet, daß das Filter als Bandsperrfilter eingestellt ist.

17. Anordnung nach Anspruch 16, dadurch gekennzeichnet, daß das als Bandsperrfilter eingestellte Filter verwendet wird, um eine Frequenzunterdrückerschaltung zu realisieren.

18. Anordnung nach einem der Ansprüche 1 bis 15, dadurch gekennzeichnet, daß das Filter als Durchgangsfilter eingestellt ist.

19. Anordnung nach Anspruch 18, dadurch gekennzeichnet, daß zwei als Durchgangsfilter eingestellte Filter gekoppelt werden, um dasselbe Eingangssignal zu empfangen und jeweils ein um 90° phasenversetztes Ausgangssignal zu liefern, um eine Phasenschieberschaltung zu realisieren.

**Claims**

1. A semiconductor device including an active filter operating in the high and very high frequency ranges, the filter having an asymmetrical input and an asymmetrical output, relative to ground, and having arranged between this input and this output:
   - a first branch comprising a series arrangement of an amplifier having a transfer function H(s) and a first impedance $Z_1$,
   - a second branch, comprising a second impedance $Z_2$ characterized in that:
   - the amplifier circuit of the first branch is chosen from an amplifier circuit having a transfer function H(s) of the order of 0, and an amplifier circuit having a low-pass transfer function H(s) of the order of 1, to fix the operating frequency ranges of the active filter;
   - the low frequency gain of the transfer function H(s) of the amplifier circuit of the first branch is controlled by control means applied to this circuit and acting in cooperation with the value and configuration of the impedances $Z_1$ and $Z_2$ for adjusting the active filter characteristics from band-stop to all-pass in said operating frequency range for the active filter;
   - the transfer function of the active filter is of the order of 2.

2. A circuit as claimed in Claim 1, characterized in that the control means are chosen between an adjustable biasing voltage applied to the amplifier circuit of the first branch and an adjustable load.

3. A device as claimed in any one of Claim 1 or 2, characterized in that:
   - the amplifier circuit has a transfer function H(s) of the order of 0;
   - the impedances $Z_1$ and $Z_2$ each comprise a resistor and a capacitor, $R_1C_1$ and $R_2C_2$, respectively;
   - and to determine the operating frequency range of the active filter, the configuration of the impedances is chosen from: a parallel filter $R_1C_1$ for the impedance $Z_1$ cooperating with a series filter $R_2C_2$ for the impedance $Z_2$ and a series filter $R_1C_1$ for the impedance $Z_1$ cooperating with a parallel filter $R_2C_2$ for the impedance $Z_2$ the frequency characteristics of the active filter

$$fo = \frac{1}{(2\pi\sqrt{R_1C_1R_2C_2})}$$

4. A device as claimed in Claim 3, characterized in that the control means applied to the amplifier determine the range of frequencies around 1 GHz and in that the configuration of the impedance $Z_1$ is a parallel filter $R_1C_1$ and the configuration of the impedance $Z_2$ is a series filter $R_2C_2$.

5. A device as claimed in Claim 3, characterized in that the control means applied to the amplifier determine the range of frequencies between approximately 1 GHz and approximately 10 GHz and in that the configuration of the impedance $Z_1$ is a series filter $R_1C_1$ and the configuration of the impedance $Z_2$ is a parallel filter $R_2C_2$.

6. A device as claimed in any one of Claim 1 or Claim 2, characterized in that:
   - the amplifier circuit has a transfer function H(s) of the order of 1,
   - the configuration of the impedance $Z_1$ arranged in series with the amplifier in the first branch is a filter formed by a resistor $R_1$ and a capacitor $C_1$ arranged in series;
   - the configuration of the impedance $Z_2$ in the second branch is a resistor $R_2$,
   - the amplifier circuit is adjusted to the required conditions for operating about its cut-off frequency which is assumed to differ from infinity.

7. A device as claimed in any one of the preceding Claims, characterized in that the transfer function of the active filter has for its expression:

$$G(s) = G\frac{(s/w_1)^2 + (1/Q_1)(s/w_1) + 1}{(s/w_0)^2 + (1/Q_0)(s/w_0) + 1}$$

in which expression:
G is the overall gain of the filter,
5 is the Laplace variable,
$w_1$ is the angular frequency associated with the zeros of G(s),
$w_0$ is the angular frequency associated with the poles of G(s),
$Q_0$ is the selectivity or quality factor of the filter,

$Q_1$ is the rejection factor of the filter.

8. A device as claimed in Claim 7, where appendant to one of the Claims 3 to 5, characterized in that the resistances $R_1$ and $R_2$ of the impedances $Z_1$ and $Z_2$ are of equal values ($R_1 = R_2$). and in that the capacitances $C_1$ and $C_2$ of the impedances $Z_1$ and $Z_2$ are equal ($C_1 = C_2$).

9. A device as claimed in Claim 8, where appendant to Claim 4, characterized in that the gain of the amplifier defined by H(s) is constant throughout the band of operating frequencies band determined for the active filter, and is chosen to be comprised between the values

H(s) = -0.5 which produces the band-stop function $1(Q_1) = 0$ for the active filter,

and H(s) = -0.2 which produces the all-pass function $Q_1 = -Q_0$ for the active filter, so that

$$- 0.2 \leqq H(s) \leqq - 0.5.$$

10. A device as claimed in Claim 6 where appendant to Claim 5, characterized in that the gain of the amplifier defined by H(s) is constant throughout the band of operating frequencies determined for the active filter, and is chosen to be comprised between the values

H(s) = -2 which produces the band-stop function for the active filter ($1/Q_1 = 0$),

H(s) = -5 which produces the all-pass function for the active filter $Q_1 = -Q_0$, so that

$$- 5 \leqq H(s) \leqq - 2.$$

11. A device as claimed in Claim 7, where appendant to Claim 6, characterized in that the non-constant gain of the amplifier circuit is defined by

$$H(s) = - k/(\tau.2\Pi.f_p + 1)$$

wherein

fp is the cut-off frequency of the amplifier

$\tau$ is the Laplace constant

and in that in the impedances $Z_1$ and $Z_2$ the values of the resistors are equal ($R_1 = R_1$) and the value of the capacitance $C_1$ in the impedance $Z_1$ is given by ($C_1/R_1$) = $2\Pi f_p$.

12. A device as claimed in Claim 11, characterized in that, to change from the band-stop function ($1Q_1 \simeq 0$) to the all-pass function ($Q_1 \simeq -Q_0$), where $w_1 \simeq_0$, the gain of the amplifier (H(S)) leads from: k = 2 (band-stop mode) to

$$k = 2 + \frac{3}{\sqrt{2}} \simeq 4.1$$

(all-pass mode)

13. A device as claimed in any one of Claims 9, 10 or 12, characterized in that the amplifier is constituted by a first transistor $T_0$ which is connected to a positive d.c. supply voltage $E_1$ across a load transistor $T_3$ whose gate is biased via a resistor $R_5$ by a positive d.c. voltage $E_2$, the gate of the amplifier transistor $T_0$ receiving the input signal $V_E$ being also biased via a resistor $R_4$ by a negative d.c. voltage $E_4$ by means of which the constant -k of the gain of the amplifier is controlled.

14. A device as claimed in Claim 13, characterized in that the resistor $R_2$ included in the impedance $Z_2$ of the second branch is constituted by a transistor $T_2$ whose gate is biased via a resistor $R_3$ by a negative d.c. voltage relative to the biasing of the source of this transistor $T_2$ by means of which $w_1$ is adjusted.

15. A device as claimed in Claim 14, where appendant to Claim 9, characterized in that the resistor $R_1$ included in the first impedance $Z_1$ of the main branch is constituted by a transistor $T_1$ whose drain is connected directly to the source of the transistor $T_2$ of the second branch realizing the resistor $R_2$ of the impedance $Z_2$ and whose gate is connected to the gate of this transistor $T_2$ for biasing in an identical manner.

16. A device as claimed in any one of the preceding Claims, characterized in that the filter is adjusted to the band-stop mode.

17. A device as claimed in Claim 16, characterized in that the filter adjusted to the band-stop mode is provided to form a frequency rejection circuit.

18. A device as claimed in any one of the Claims 1 to 15, characterized in that the filter is adjusted to the all-pass mode.

19. A device as claimed in Claim 18, characterized in that two filters adjusted to the all-pass mode are associated in such a manner as to receive the same input signal and to each supply an output signal shifted through 90° to form a phase-shifting circuit.

FIG.1a

FIG.1b

FIG.1c

26

FIG. 2a

FIG. 2b

FIG. 2 c

FIG. 2d

FIG. 2e

FIG. 2f

FIG. 3a

FIG. 3b

FIG. 3c

FIG. 3d

FIG. 3e

FIG. 3f

FIG. 3g

$\left|\dfrac{V_{S1}}{V_{S2}}\right|$ (dB)

FIG. 3h

$\Delta\varphi$ (°)

FIG. 3i

$\triangle\varphi(°)$

91.5

91.0

90.5

90.0

89.5

E21=2V

89.0

E21=2,5V

E21=3V

88.5

6        6.5       7       7.5       8       8.5       9       9.5      10

(GHz)

## FIG. 3 j

$\left|\dfrac{V_{S1}}{V_{S2}}\right|$ (dB)

0.20

0.15

0.10

0.05

0.00

E21=3V

−0.05

E21=2,5V

−0.10

E21=2V

−0.15

−0.20

6        6.5       7       7.5       8       8.5       9       9.5      10

(GHz)

## FIG. 3k

FIG. 4

FIG. 5

FIG. 6